(19) Europäisches Patentamt
European Patent Office
Office européen des brevets

(11) **EP 4 045 925 B1**

(12) **EUROPÄISCHE PATENTSCHRIFT**

(45) Veröffentlichungstag und Bekanntmachung des Hinweises auf die Patenterteilung:
**07.05.2025   Patentblatt 2025/19**

(21) Anmeldenummer: **20799987.1**

(22) Anmeldetag: **14.10.2020**

(51) Internationale Patentklassifikation (IPC):
**G01R 31/367** (2019.01)      **G01R 31/392** (2019.01)

(52) Gemeinsame Patentklassifikation (CPC):
**G01R 31/367; G01R 31/392;** G01R 31/3835

(86) Internationale Anmeldenummer:
**PCT/DE2020/100887**

(87) Internationale Veröffentlichungsnummer:
**WO 2021/073690 (22.04.2021 Gazette 2021/16)**

(54) **VERFAHREN UND VORRICHTUNG ZUR BESTIMMUNG DES LADEZUSTANDES UND DES GESUNDHEITSZUSTANDES EINER AUFLADBAREN BATTERIE**

METHOD AND DEVICE FOR DETERMINING THE STATE OF CHARGE AND THE STATE OF HEALTH OF A RECHARGEABLE BATTERY

PROCÉDÉ ET DISPOSITIF POUR DÉTERMINER L'ETAT DE CHARGE ET L'ÉTAT DE SANTÉ D'UNE BATTERIE RECHARGEABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität:  **15.10.2019   DE 102019127828**

(43) Veröffentlichungstag der Anmeldung:
**24.08.2022   Patentblatt 2022/34**

(73) Patentinhaber: **Benning CMS Technology GmbH**
**79232 March (DE)**

(72) Erfinder: **BESSLER, Wolfgang**
**77654 Offenburg (DE)**

(74) Vertreter: **Eder Schieschke & Partner mbB**
**Patentanwälte**
**Elisabethstraße 34**
**80796 München (DE)**

(56) Entgegenhaltungen:
**EP-A1- 3 174 175          US-A1- 2011 093 223**
**US-A1- 2014 203 813      US-A1- 2019 170 827**

**Beschreibung**

Die Erfindung betrifft ein Verfahren zur Bestimmung des Ladezustandes einer aufladbaren Batterie eines vorgegebenen Batterietyps oder eines damit in einem physikalischen Zusammenhang stehenden Parameters, insbesondere einer in der Batterie enthaltenen Restladungsmenge sowie ein Verfahren zur Bestimmung des Gesundheitszustandes einer aufladbaren Batterie eines vorgegebenen Batterietyps oder eines damit in einem physikalischen Zusammenhang stehenden Parameters, insbesondere einer aktuellen Kapazität der Batterie. Weiterhin betrifft die Erfindung eine Vorrichtung zur Durchführung dieser Verfahren.

Der Ladezustand (State of Charge, SOC) einer aufladbaren Batterie ist definiert als

$$SOC = \frac{Q}{C}.$$

Der Gesundheitszustand (State Of Health, SOH) einer aufladbaren Batterie ist definiert als

$$SOH = \frac{C}{C_N}.$$

In diesen Gleichungen ist mit $Q$ die restliche Ladungsmenge in der Batterie, mit $C$ die Kapazität, d.h. die aus einer voll geladenen Batterie entnehmbare Ladungsmenge, und mit $C_N$ die Nennkapazität, d.h. die Kapazität einer neuen Batterie, bezeichnet. SOC und SOH sind dabei als dimensionslose Größen zwischen 0 und 1 definiert. In der Praxis werden SOC und SOH häufig als Prozentwert angegeben.

Die SOC-Bestimmung wird heute in vielen Batteriesystemen von einem sogenannten Batteriemanagementsystem (BMS) durchgeführt, welches diese Information dem Benutzer zur Verfügung gestellt, beispielsweise mittels eines Displays. Zur näherungsweisen Bestimmung des SOC sind eine Vielzahl verschiedener Verfahren bekannt, darunter unter anderem modellbasierte Verfahren. Diese arbeiten ausschließlich auf der Basis stromgeführter Batteriemodelle, so dass als Eingangssignal Messwerte für den Batteriestrom notwendig sind. Strommessungen sind jedoch nicht mit der gewünschten Genauigkeit möglich, so dass die Genauigkeit der bekannten Verfahren zur Bestimmung des SOC oftmals nicht gut genug ist.

Beispielsweise sind aus der US 2014/0203813 A1 und der US 2011/0093223 A1 Verfahren und Vorrichtungen zur Bestimmung des SOC einer Batterie bekannt, welche auf derartigen (zumindest auch) stromgeführten Modellen basieren. Die Bestimmung des SOC erfolgt mit Hilfe eines Beobachters, der als Kalmann-Filter realisiert sein kann.

Verfahren zur Bestimmung des SOH beruhen oftmals auf der Messung des Batteriestroms während eines Zyklus zwischen einem vollständig entladenen und einem vollständig geladenen Zustand der Batterie. Dies ist jedoch während des normalen Einsatzes der Batterie nicht möglich.

In der US 2019/0170827 wird ein Verfahren zur Bestimmung des SOH vorgeschlagen, welches ebenfalls auf der Verwendung eines Beobachters basiert, der als Kalman-Filter ausgebildet ist. Die Verwendung eines Beobachters erfordert einen beträchtlichen Rechenaufwand bei der Implementierung. Weiterhin offenbart die EP 3 174 175 A1 eine Vorrichtung zur sicheren Verwendung einer Batterie, welche hierzu den SOH der Batterie als Funktion eines Quotienten bestimmt, der gebildet wird aus einer Differenz von zum Beginn und zum Ende eines Beobachtungszeitraums gemessenen Batterie-Spannungswerten und aus der in dem Beobachtungszeitraum erfassten Energie, die von der Batterie geliefert bzw. von dieser aufgenommen wird.

Ausgehend von diesem Stand der Technik liegt der Erfindung die Aufgabe zugrunde, ein Verfahren zur näherungsweisen Bestimmung des Ladezustands einer aufladbaren Batterie eines vorgegebenen Batterietyps oder eines damit in einem physikalischen Zusammenhang stehenden Parameters, insbesondere einer in der Batterie enthaltenen Restladungsmenge zu schaffen, welches einfach und bei geringem Rechenaufwand in einem Batteriemanagementsystem implementierbar ist. Weiterhin liegt der Erfindung die Aufgabe zugrunde, ein Verfahren zur Bestimmung des Gesundheitszustandes einer aufladbaren Batterie eines vorgegebenen Batterietyps oder eines damit in einem physikalischen Zusammenhang stehenden Parameters, insbesondere einer aktuellen Kapazität der Batterie, zu schaffen, welches die Bestimmung eines Näherungswertes für den Gesundheitszustand der Batterie während des normalen Einsatzes der Batterie ermöglicht und welches einfach und bei geringem Rechenaufwand in einem Batteriemanagementsystem implementierbar ist.. Schließlich liegt der Erfindung die Aufgabe zugrunde, eine Vorrichtung zu schaffen, welche die Durchführung eines oder beider der vorgenannten Verfahren ermöglicht.

Die Erfindung wird definiert durch die unabhängigen Ansprüche. Vorteilhafte Ausbildungsformen sind in den abhängigen Ansprüchen definiert.

Die Erfindung geht von der Erkenntnis aus, dass die Verwendung eines spannungsgeführten dynamischen mathematischen Batteriemodells, welches durch ein implizites Gleichungssystem beschrieben wird, die einfache Bestimmung eines Näherungswertes für den SOC ermöglicht. Hierzu muss lediglich die Batteriespannung (über eine bestimmte Zeitspanne) gemessen werden. Abhängig von dem konkret gewählten Batteriemodell können darüber hinaus die Temperatur der Batterie bzw. die Umgebungstemperatur als Eingangsgrößen für das Batteriemodell verwendet werden. Auch kann das Modell bestimmte Zeitabhängigkeiten, beispielsweise ein Hystereseverhalten der Batterie oder eine Zeitabhängigkeit von Doppelschichten, beinhalten.

Gleichzeitig liefert das spannungsgeführte Batteriemodell den (Modell-) Batteriestrom als Ausgangsgröße. Dieser wird erfindungsgemäß zur Bestimmung des SOH der Batterie verwendet.

Das Verfahren nach der Erfindung nutzt ein dynamisches mathematisches Batteriemodell für die Batterie oder den vorgegebenen Batterietyp (d.h. eine Vielzahl gleichartiger Batterien), welches einen Ladezustand der Batterie $SOC_{mod}$ oder einen damit in einem physikalischen Zusammenhang stehenden Parameter, insbesondere die in der Batterie enthaltene Restladungsmenge Q, mit einem Batteriestrom $I_{mod}$ verknüpft und welches eine zwischen zwei Anschlüssen (Polen) der Batterie gemessene Spannung $U_{mess}$ in Abhängigkeit von einer Summe aus einer Leerlaufspannung $U^0$ der Batterie und einer Überspannung $\eta$ definiert, wobei die Leerlaufspannung $U^0$ zumindest von der restlichen Ladungsmenge Q oder dem damit in einem physikalischen Zusammenhang stehenden Parameter und die Überspannung $\eta$ zumindest von dem Batteriestrom $I_{mod}$ abhängt.

Dieses dynamische mathematische Batteriemodell kann dann für die spezielle Batterie oder einen speziellen Batterietyp parametriert werden, d.h. die Parameter für das Batteriemodell werden so gewählt, dass das parametrierte Modell die spezielle Batterie oder den speziellen Batterietyp mit ausreichender Genauigkeit beschreibt.

Damit ermöglicht das erfindungsgemäße Verfahren die Bestimmung eines Näherungswertes $SOC_{mod}$ für den tatsächlichen Ladezustand SOC der Batterie oder den damit in einem physikalischen Zusammenhang stehenden Parameter durch Messen der Batteriespannung $U_{mess}$ und Berechnen des Näherungswertes $SOC_{mod}$ unter Verwendung des parametrierten dynamischen mathematischen Batteriemodells.

Eine Vorrichtung zur Durchführung dieses Verfahrens muss somit lediglich dazu ausgebildet sein, die Batteriespannung $U_{mess}$ zu messen, beispielsweise mittels einer Einheit zur Messung der Batteriespannung $U_{mess}$, und aus der gemessenen Batteriespannung $U_{mess}$ den Näherungswert $SOC_{mod}$ für den SOC der Batterie zu berechnen. Hierzu kann die Vorrichtung eine Recheneinheit zur Berechnung des SOC umfassen. Das parametrierte Batteriemodell kann hierzu ebenfalls in der Rechnungseinheit gespeichert sein oder dieser von einer übergeordneten Einheit zugeführt werden.

Das Batteriemodell ermöglicht darüber hinaus auch eine Berechnung des (Modell-) Batteriestroms $I_{mod}$. Dieser kann erfindungsgemäß in einem weiteren Schritt auch zur Bestimmung eines Näherungswertes $SOH_{mod}$ für den tatsächlichen SOH der Batterie verwendet werden (siehe unten). Dabei ist es nicht zwingend erforderlich, dass bei der Verwendung des erfindungsgemäßen Verfahrens zur Bestimmung eines Näherungswertes für den SOH einer Batterie auch der SOC der Batterie bestimmt wird. Denn selbstverständlich ermöglicht die Verwendung eines spannungsgeführten dynamischen mathematischen Batteriemodells, dass nur der (Modell-) Batteriestrom $I_{mod}$ berechnet wird, ohne dass zuvor oder gleichzeitig der SOC der Batterie ausgegeben oder verwendet werden müsste.

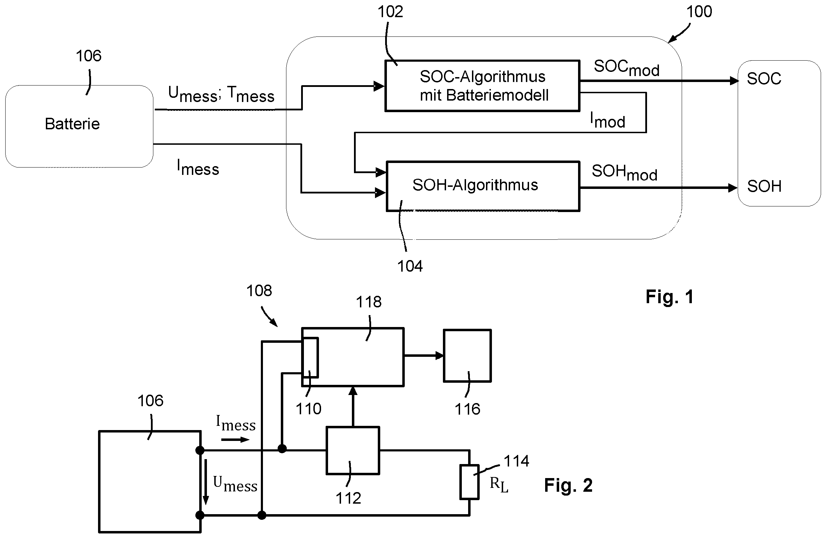

In seiner vollen Ausgestaltung schafft das erfindungsgemäße Verfahren jedoch einen Algorithmus (eine mathematische Vorschrift), der es ermöglicht, aus Messwerten für die Batteriespannung $U_{mess}$ und die Stromstärke $I_{mess}$ der Batterie - und optional aus Messwerten für die Temperatur $T_{mess}$ der Batterie bzw. der Umgebungstemperatur - den Ladezustand SOC und den Gesundheitszustand SOH zu bestimmen. Dieses voll ausgestaltete Verfahren ist in Fig. 1 schematisch dargestellt. Es besteht aus einem Gesamt-Algorithmus 100, der zwei Bestandteile umfasst, nämlich einen ersten Bestandteil 102 mit einem Batteriemodell und einem Algorithmus zur SOC-Bestimmung und einem zweiten Bestandteil 104 mit einem SOH-Algorithmus zur SOH-Bestimmung. Dem ersten Bestandteil 102 ist als zwingend notwendige Eingangsgröße die gemessene Batteriespannung $U_{mess}$ zugeführt und optional die gemessene Temperatur $T_{mess}$ der Batterie. Statt der gemessenen Temperatur $T_{mess}$ kann dem Batteriemodell auch die Umgebungstemperatur $T^{umg}$ zugeführt werden, wenn das Batteriemodell ein thermisches Teilmodell umfasst. Der erste Algorithmus-Bestandteil 102 mit dem dynamischen mathematischen Batteriemodell liefert als Ausgangsgröße in der vollen Ausgestaltung des erfindungsgemäßen Verfahrens einen Wert $SOC_{mod}$, der als Näherungswert für den tatsächlichen SOC der Batterie 106 verwendet wird. Der zweite Algorithmus-Bestandteil 104 erhält als Eingangsgrößen zum einen den mittels des Batteriemodells berechneten Wert für den Modell-Batteriestrom $I_{mod}$ und zum anderen den gemessenen Batteriestrom $I_{mess}$. Als Ausgangsgröße liefert der zweite Algorithmus-Bestandteil einen Wert $SOH_{mod}$, der als Näherungswert für den tatsächlichen SOH der Batterie 106 verwendet wird.

Nach einer Ausgestaltung der Erfindung besteht das dynamische mathematische Batteriemodell aus einem impliziten Gleichungssystem oder kann hieraus entwickelt sein, welches folgende Gleichungen umfasst:

$$\frac{\mathrm{dSOC_{mod}}}{\mathrm{d}t} = -\frac{I_{mod}}{C_N}$$

$$U_{mess} = U^0(SOC_{mod}, T_{mess}, t) + \eta(I_{mod}, SOC_{mod}, T_{mess}, t)$$

wobei mit $C_N$ eine vorgegebenen Nennkapazität der Batterie, mit $T_{mess}$ eine gemessene Temperatur der Batterie und mit t die Zeit bezeichnet ist, wobei die Leerlaufspannung $U^0$ zwingend eine Abhängigkeit vom Ladezustand $SOC_{mod}$ zeigt, während die Abhängigkeit von der gemessenen Temperatur $T_{mess}$ und der Zeit t optional ist, und wobei die Überspannung $\eta$ zwingend eine Abhängigkeit vom Batteriestrom $I_{mod}$ zeigt, während die Abhängigkeit vom Ladezustand $SOC_{mod}$, der gemessenen Temperatur $T_{mess}$ und der Zeit t optional ist.

Diese beiden noch sehr allgemein formulierten Beziehungen beschreiben implizit das zeitliche Verhalten der beiden gesuchten Unbekannten $SOC_{mod}$ und $I_{mod}$. Während die erste Gleichung lediglich beschreibt, dass die Änderung der in der Batterie enthaltenen Restladung dem Batteriestrom entspricht und für alle weiteren, speziellen Ausgestaltungen bzw. Formulierungen des mathematischen Batteriemodells in dieser Weise übernommen werden kann, kann die zweite Gleichung auf ein speziell gewähltes Batteriemodell angepasst werden und erforderlichenfalls durch ein komplexes Gleichungssystem ersetzt werden, welches das gewählte Batteriemodell mathematisch-physikalisch beschreibt.

Beispielsweise kann nach einer Ausgestaltung der Erfindung die Leerlaufspannung $U^0$ als ausschließlich vom Ladezustand $SOC_{mod}$ abhängig und ein konstanter Innenwiderstand $R_i$ der Batterie vorausgesetzt werden. Weiterhin kann angenommen werden, dass das Batteriemodell temperaturunabhängig ist. In diesem Fall können die vorstehenden, allgemeinen Gleichungen für das Batteriemodell durch die folgenden Gleichungen ersetzt werden:

$$\frac{dSOC_{mod}}{dt} = -\frac{I_{mod}}{C_N}$$

$$U_{mess} = U^0(SOC_{mod}) - R_i \cdot I_{mod},$$

wobei die Abhängigkeit der Leerlaufspannung $U^0$ vom Ladezustand $SOC_{mod}$ insbesondere durch Messung, insbesondere als gemessene diskrete Werte oder als analytische Funktion, ermittelt wird. In diesem Fall ergibt sich ein sehr einfach zu lösendes Gleichungssystem, das mit geringem Aufwand in ein Batteriemanagementsystem implementiert werden kann.

Im Fall dieses Batteriemodells können die beiden vorstehenden Gleichungen durch analytische Inversion gelöst werden, wobei der Ladezustand $SOC_{mod}$ aus den Gleichungen

$$\frac{dSOC_{mod}}{dt} = -\frac{1}{R_i \cdot C_N} \cdot (U^0(SOC_{mod}) - U_{mess})$$

$$I_{mod} = \frac{1}{R_i}(U^0(SOC_{mod}) - U_{mess})$$

berechnet werden kann. Die Abhängigkeit $U^0(SOC_{mod})$ kann dabei entweder tabellarisch, d.h. in Form von Messwerten, oder in Form einer analytischen Funktion angegeben werden. Bereits an dieser Stelle sei bemerkt, dass selbstverständlich aus diesen Gleichungen auch der Modellstrom $I_{mod}$ berechnet werden kann, wenn zusätzlich zum SOC auch der SOH ermittelt werden soll. Abhängig von dem gewählten Verfahren zur Lösung der beiden vorgenannten Gleichungen kann zur Berechnung des SOC auch nur die erstgenannte Gleichung genügen. Soll zusätzlich auch der modellierte Batteriestrom $I_{mod}$ berechnet werden, so muss in jedem Fall auch die zweitgenannte Gleichung herangezogen werden.

In der Praxis wird man die vorgenannten Gleichungspaare zur Berechnung des $SOC_{mod}$ mittels numerischer Verfahren lösen, da auch die dem Algorithmus zur Bestimmung des $SOH_{mod}$ zugeführten Eingangsgrößen in Form von diskreten Messwerten erfasst werden, vorzugsweise in einem äquidistanten zeitlichen Abstand $\Delta t$ (Abtastintervall).

Insbesondere die Spannung $U_{mess}$ wird dabei in Form von diskreten Spannungsmesswerten $U_{mess}^i$ in einem vorgegebenen zeitlichen Abstand $\Delta t$ erfasst. Der vorgegebene zeitliche Abstand kann auch variieren. Die Messwerte können auch zu vorgegebenen Zeitpunkten erfasst werden.

Zur numerischen Lösung der vorstehenden Gleichungen für das angenommene, sehr einfache Batteriemodell kann die explizite Vorwärts-Euler-Methode zur Diskretisierung verwendet werden. Diese Diskretisierungsmethode führt zu den Beziehungen

$$SOC_{mod}^{i+1} = SOC_{mod}^i - \frac{\Delta t}{R_i \cdot C_N} \cdot \left(U^0\left(SOC_{mod}^i\right) - U_{mess}^i\right)$$

$$I_{\text{mod}}^i = \frac{1}{R_{\text{i}}}\left(U^0\big(\text{SOC}_{\text{mod}}^i\big) - U_{\text{mess}}^i\right)$$

wobei die jeweiligen Größen mit einem Index i versehen sind, welcher einen Zeitschritt um Δt bezeichnet. Selbstverständlich muss ein geeigneter Startwert für $\text{SOC}_{\text{mod}}^{i=0}$ gewählt werden.

Anstelle der expliziten Vorwärts-Euler-Methode können auch andere explizite oder auch implizite Methoden zur Diskretisierung der vorstehenden Gleichungen verwendet werden. Bei der impliziten Rückwärts-Euler-Methode ist jedoch keine geschlossene Lösung mehr möglich. In diesem Fall müssen weitere numerische Verfahren, wie z.B. das Newton-Verfahren, eingesetzt werden.

Ein Spezialfall ergibt sich jedoch, wenn nach einer Ausgestaltung der Erfindung ein linearer Zusammenhang zwischen der Leerlaufspannung und dem SOC der Batterie angenommen wird. Damit vereinfachen sich die Gleichungen für das oben angegebene einfache Batteriemodell weiter zu

$$\frac{\text{dSOC}_{\text{mod}}}{\text{d}t} = -\frac{1}{R_{\text{i}} \cdot C_{\text{N}}}\big((U_L - U_E) \cdot \text{SOC}_{\text{mod}} + U_E - U_{\text{mess}}\big)$$

und

$$I_{\text{mod}} = \frac{1}{R_{\text{i}}}\big((U_L - U_E) \cdot \text{SOC}_{\text{mod}} + U_E - U_{\text{mess}}\big)$$

wobei mit $U_L$ eine Ladeschlussspannung und mit $U_E$ eine Entladeschlussspannung bezeichnet ist.

Aus diesen Gleichungen kann der Näherungswert für den Ladezustand SOC, also der Wert $\text{SOC}_{\text{mod}}$, unter Verwendung eines mathematischen Diskretisierungsverfahrens und ggf. weiterer numerischer Verfahren berechnet werden. Setzt man die implizite Rückwärts-Euler-Methode ein, so führt dies zu den Gleichungen

$$I_{\text{mod}}^{i+1} = \frac{1}{\frac{(U_L - U_E)}{C_{\text{N}}}\Delta t + R_i}\left((U_L - U_E) \cdot \text{SOC}_{\text{mod}}^i + U_E - U_{\text{mess}}^{i+1}\right)$$

und

$$\text{SOC}_{\text{mod}}^{i+1} = \text{SOC}_{\text{mod}}^i - \frac{I_{\text{mod}}^{i+1}}{C_{\text{N}}}\Delta t,$$

aus welchen $\text{SOC}_{\text{mod}}$ ebenfalls auf einfache Weise berechnet werden kann. Wie bereits erwähnt, müsste zur Bestimmung von $\text{SOH}_{\text{mod}}$ nicht zwingend auch ein Wert für den Batteriestrom $I_{\text{mod}}$ berechnet werden, jedoch ergibt sich dieser in diesem speziellen Fall infolge der Kopplung der beiden Gleichungen ohnehin von selbst.

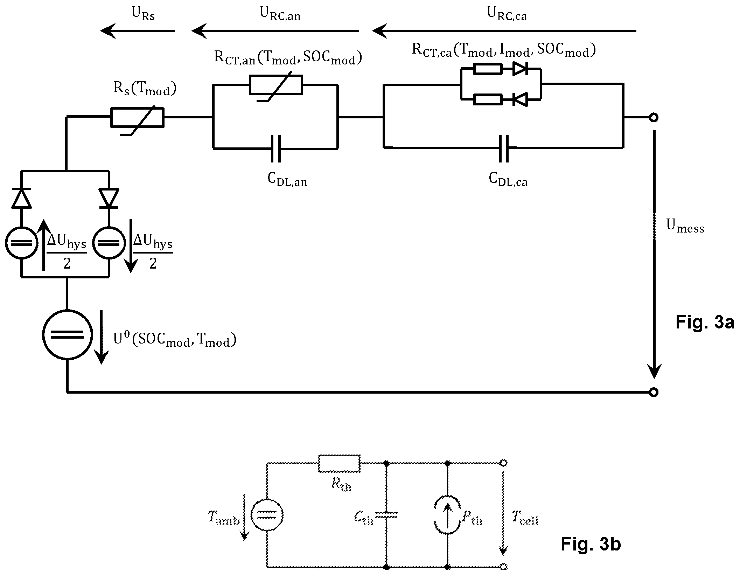

Nach einer weiteren Ausführungsform der Erfindung kann das Verfahren zur Bestimmung des SOC bzw. SOH der Batterie auch mittels eines relativ komplexen Äquivalenzschaltkreismodells für die Batterie gemäß Fig. 3 durchgeführt werden. Dieses Batteriemodell kann durch die folgenden Gleichungen beschrieben werden:

$$\frac{\text{dSOC}_{\text{mod}}}{\text{d}t} = -\frac{I_{\text{mod}}}{C_{\text{N}}}$$

$$U_{\text{mess}} = U^0(\text{SOC}_{\text{mess}}, T_{\text{mod}}) + \Delta U_{\text{hys}}(I_{\text{mod}}) - U_{\text{RC,an}} - U_{\text{RC,ca}} - I_{\text{mod}} \cdot R_s(T_{\text{mod}})$$

$$\frac{\text{d}U_{\text{RC,an}}}{\text{d}t} = \frac{1}{C_{\text{DL,an}}(T_{\text{mod}})}\left(I_{\text{mod}} - \frac{U_{\text{RC,an}}}{R_{\text{CT,an}}(T_{\text{mod}})}\right)$$

$$\frac{\mathrm{d}U_{RC,\mathrm{ca}}}{\mathrm{d}t} = \frac{1}{C_{\mathrm{DL,ca}}(T_{\mathrm{mod}})}\left(I_{\mathrm{mod}} - \frac{U_{RC,\mathrm{ca}}}{R_{\mathrm{CT,ca}}(T_{\mathrm{mod}}, I_{\mathrm{mod}})}\right)$$

$$\frac{\mathrm{d}T_{\mathrm{mod}}}{\mathrm{d}t} = \frac{1}{C_{\mathrm{th}}}\left(I_{\mathrm{mod}}^2 R_s(T_{\mathrm{mod}}) + \frac{U_{\mathrm{RC,an}}^2}{R_{\mathrm{CT,an}}(T_{\mathrm{mod}})} + \frac{U_{\mathrm{RC,ca}}^2}{R_{\mathrm{CT,ca}}(T_{\mathrm{mod}}, I_{\mathrm{mod}})} - \frac{T_{\mathrm{mod}} - T_{\mathrm{mess}}^{\mathrm{Umg}}}{R_{\mathrm{th}}} + I_{\mathrm{mod}} \cdot\right.$$
$$\left. (T_{\mathrm{mod}} - T^0) \cdot \frac{\mathrm{d}U^0(\mathrm{SOC}_{\mathrm{mod}})}{\mathrm{d}T}\right)$$

**wobei mit** $U_{RC}$ ein Spannungsabfall über ein RC-Element bezeichnet ist, mit $R_{CT}$ ein Ladungstransferwiderstand, mit $C_{DL}$ eine Doppelschichtkapazität, mit $C_{th}$ eine Wärmekapazität, mit $R_{th}$ ein Wärmeübergangswiderstand an der Batterie-oberfläche, mit $\mathrm{d}U^0(\mathrm{SOC}_{\mathrm{mod}})/\mathrm{d}T$ eine Temperaturabhängigkeit der Leerlaufspannung, mit $T^0$ eine zugehörige Refe-renztemperatur und mit $T_{\mathrm{mess}}^{\mathrm{Um}}$ eine gemessene Umgebungstemperatur der Batterie, wobei die Indizes "an" und ca" auf eine Anode und eine Kathode der Batterie verweisen und wobei eine Asymmetrie der Leerlaufspannung $U^0$ durch $\Delta U_{\mathrm{hys}}$ beschrieben wird und eine Asymmetrie des Kathodenwiderstands durch eine Stromabhängigkeit von $R_{\mathrm{CT,ca}}$. Aus diesem Gleichungssystem kann der Wert für SOC$_{\mathrm{mod}}$, also ein Näherungswert für den tatsächlichen Ladezustand SOC, berechnet werden, vorzugsweise mittels eines oder mehrerer numerischer mathematischer Verfahren.

Das Verfahren nach der Erfindung zur Bestimmung des Gesundheitszustandes einer aufladbaren Batterie eines vorgegebenen Batterietyps oder eines damit in einem physikalischen Zusammenhang stehenden Parameters, insbesondere einer aktuellen Kapazität C der Batterie, umfasst folgende Schritte:

- Erstellen eines spannungsgeführten, für die Batterie oder den vorgegebenen Batterietyp parametrierten dynamischen mathematischen Batteriemodells mit den vorstehend erläuterten Merkmalen,

- Bestimmung einer von der Batterie während eines ersten Beobachtungszeitraums aufgenommenen Ladungsmenge Q$_{\mathrm{in,mess}}$ und einer von der Batterie während einer zweiten Beobachtungszeitraums abgegebenen Ladungsmenge Q$_{\mathrm{out,mess}}$ durch Messung und Integration eines von der Batterie abgegebenen oder aufgenommenen Batteriestroms I$_{\mathrm{mess}}$, wobei der zweite Beobachtungszeitraum vorzugsweise identisch oder zumindest überlappend mit dem ersten Beobachtungszeitraum gewählt ist;

- Berechnung einer von der Batterie während des ersten Beobachtungszeitraums aufgenommenen Ladungsmenge Q$_{\mathrm{in,mod}}$ und einer von der Batterie während des zweiten Beobachtungszeitraums abgegebenen Ladungsmenge Q$_{\mathrm{out,mod}}$ unter Verwendung eines spannungsgeführten, für die Batterie oder den vorgegebenen Batterietyp parametrierten dynamischen mathematischen Batteriemodells,

- Bestimmung eines Näherungswertes SOH$_{\mathrm{mod}}$ für den tatsächlichen Gesundheitszustand SOH durch Berechnen eines Lade-Gesundheitszustandes SOH$_{\mathrm{in}}$ als Quotient aus der Ladungsmenge Q$_{\mathrm{in,mess}}$ und der Ladungsmenge Q$_{\mathrm{in,mod}}$ und/oder eines Entlade-Gesundheitszustandes SOH$_{\mathrm{out}}$ als Quotient aus der Ladungsmenge Q$_{\mathrm{out,mess}}$ und der Ladungsmenge Q$_{\mathrm{out,mod}}$ und Verwenden des Lade-Gesundheitszustandes SOH$_{\mathrm{in}}$ oder des Entlade-Gesund-heitszustandes SOH$_{\mathrm{out}}$ oder eines hieraus berechneten Mittelwertes als Näherungswert SOH$_{\mathrm{mod}}$ für den tatsäch-lichen Gesundheitszustand SOH.

Dabei sei klargestellt, dass in dem Schritt zu Berechnung der Ladungsmengen Q$_{\mathrm{in,mod}}$ bzw. Q$_{\mathrm{out,mod}}$ unter Verwendung des spannungsgeführten Batteriemodells selbstverständlich auch Messdaten für die Spannung der Batterie verwendet werden.

Nach einer Ausführungsform können der erste und der zweite Zeitraum so gewählt werden, dass die während des betreffenden Zeitraums geladenen Ladungsmengen Q$_{\mathrm{in,mess}}$ und/oder entladenen Ladungsmengen Q$_{\mathrm{out,mess}}$ und/oder die Betragssumme hiervon größer sind als ein jeweils vordefinierter Wert, wobei der vordefinierte Wert vorzugsweise größer als die Nennkapazität C$_N$ der Batterie ist. Hierdurch kann eine ausreichende Genauigkeit des ermittelten Wertes SOH$_{\mathrm{mod}}$ gewährleistet werden.

Nach einer weiteren Ausführungsform können die Endzeitpunkte des ersten und zweiten Zeitraums so gewählt werden, dass an den Endzeitpunkten derselbe Ladezustand SOC$_{\mathrm{ref}}$ besteht wie an den Anfangszeitpunkten und/oder dass an den Endzeitpunkten dieselbe Stromrichtung des gemessenen Batteriestroms I$_{\mathrm{mess}}$ herrscht wie an den Anfangszeitpunkten. Hierdurch kann der Einfluss von Hystereseeffekten oder Modellabweichungen reduziert werden.

Die vorstehend erläuterten Varianten von Batteriemodellen und die hierfür dargestellten Verfahren zur Lösung der Gleichungssysteme ermöglichen auf einfache Weise die Berechnung des Batteriestroms I$_{\mathrm{mod}}$. Die Ladungsmengen

$Q_{in,mod}$ und $Q_{out,mod}$ können erfindungsgemäß in einfacher Weise durch analytische oder numerische Integration des aus dem dynamischen mathematischen Batteriemodell berechneten Batteriestroms $I_{mod}$ berechnet werden. Somit kann auch der Näherungswert $SOH_{mod}$ für den tatsächlichen Gesundheitszustand der Batterie sehr einfach bestimmt werden.

Weitere Ausführungsformen der Erfindung ergeben sich aus den Unteransprüchen.

Die Erfindung wird nachstehend anhand in der Zeichnung dargestellter Ausführungsbeispiele näher erläutert. In der Zeichnung zeigen:

Fig. 1 eine Prinzipdarstellung des Verfahrens nach der Erfindung;

Fig. 2 ein schematisches Blockdiagramm einer unter Last betriebenen Batterie mit einer Vorrichtung nach der Erfindung zur Durchführung des Verfahrens;

Fig. 3 ein spezielles, komplexes Äquivalenzschaltkreismodell für eine Lithiumeisenphosphat-basierte Lithium-Ionen-Zelle, welches aus einem elektrischen Teilmodell (Fig. 3a) und einem thermischen Teilmodell (Fig. 3b) besteht;

Fig. 4 ein $U^0$(SOC)-Diagramm einer Lithium-Ionen-Batterie mit Nickel-Mangan-Kobaltoxid/Graphit-Chemie (NMC-Graphit) des Herstellers Kokam, Typ SLPB533459H4, mit einer Nennkapazität von 0,74 Ah und einer Nennspannung von 3,7 V;

Fig. 5 simulierte Entlade-Lade-Kennlinien (Batteriespannung gegenüber Ladungsmenge) für die Batterie gem. Fig. 3 bei drei Temperaturen (Fig. 5a bei 5°C; Fig. 5b bei 20°C und Fig. 5c bei 35°C) und drei Stromstärken (0,06C, 0,28C, 0,93C), wobei zur Simulation das Modell B auf diese Batterie parametriert wurde;

Fig. 6 einen Ausschnitt der 100 aufeinanderfolgenden Ladezyklen nach Birkl für die Batterie gemäß Fig. 4, wobei Fig. 6a die gemessene Spannung $U_{mess}$ als Eingangsgröße für das Batteriemodell zeigt und Fig. 6b die gemessene Stromstärke (Kurve (a) und die mit dem Batteriemodel (Modell A) berechnete Stromstärke (Kurve (b));

Fig. 7 Ergebnisse des neuen Verfahrens (nach dem Modell A) für die Batterie gemäß Fig. 4, wobei Fig. 7a den Ladezustand SOC während der ersten Stunden der Zyklierung nach Birkl darstellt und Fig. 7b den Ladezustand SOC während der letzten Stunden; den Ergebnissen des Verfahrens (Kurven (b)) sind nach einem herkömmlichen Verfahren ermittelte Ergebnisse gegenübergestellt (Kurven (a));

Fig. 8 Ergebnisse des neuen Verfahrens für den Gesundheitszustand SOH über die gesamte Versuchsdauer (Kurve (b)) unter Verwendung des Modells A; diesen Ergebnissen gegenübergestellt ist eine SOH-Kurve, die durch Ladungszählung gewonnen wurde (Kurve (v));

Fig. 9 Ergebnisse eines Experiments mit dem neuen Verfahren für eine Lithium-Ionen-Batterie für stationäre Speicher mit LFP-Graphit-Chemie mit einer Nennkapazität von 158 Ah für eine Vielzahl von Entlade- und Ladezyklen; Fig. 9a zeigt die gemessene Spannung und Fig. 9b zeigt die gemessene (Kurve (a)) und die modellierte (Kurve (b)) Stromstärke (unter Verwendung des Batteriemodells B); und

Fig. 10 Ergebnisse dieses Verfahrens für den SOC (Fig. 10a; Kurven (b)) und den SOH (Fig. 10b); den Ergebnissen des Verfahrens gegenübergestellt ist eine präzise Vergleichsmessung (Kurven (v)).

Die Fig. 1 und 2 zeigen eine schematische Darstellung der Vorrichtung bzw. des Verfahrens nach der Erfindung zur Bestimmung des SOH und SOC einer Batterie 106, die an einer Last $R_L$ betrieben wird. Wie aus Fig. 1 ersichtlich, lässt sich das Verfahren mittels eines Gesamt-Algorithmus 100 realisieren, beispielsweise durch Integration in ein bereits vorhandenes Batteriemanagementsystem. Der Gesamt-Algorithmus 100 umfasst einen ersten Bestandteil 102 zur SOC-Bestimmung, der auch ein für die spezielle Batterie oder den speziellen Batterietyp gewähltes dynamisches mathematisches Batteriemodell umfasst. Diesem ersten Bestandteil sind als Eingangsgrößen die gemessene Batteriespannung $U_{mess}$ und die gemessene Temperatur $T_{mess}$ der Batterie zugeführt. Anstelle der gemessenen Temperatur der Batterie kann diesem ersten Bestandteil des Gesamt-Algorithmus 100 auch die gemessene Umgebungstemperatur $T_{mess}^{umg}$ zugeführt werden. Dieser erste Bestandteil des Gesamt-Algorithmus ist in der Lage, aus der gemessenen Batteriespannung $U_{mess}$ (Eingangsgröße) den Ladezustand $SOC_{mod}$ und die Stromstärke $I_{mod}$ (Ausgangsgrößen) der Batterie zu berechnen. Die Art des Batteriemodells selbst ist für das Verfahren unerheblich, so lange es diese Anforderungen erfüllt. Vorstellbar sind empirische Modelle, Äquivalenzschaltkreismodelle, multiphysikalische Modelle oder andere Modelle. Für die SOC-Bestimmung wird nur die Ausgangsgröße $SOC_{mod}$ benötigt.

Zur Bestimmung des SOH weist der Gesamt-Algorithmus 100 einen zweiten Bestandteil 104 auf, dem als Eingangsgröße der mittels des ersten Bestandteils 102 berechnete Strom I$_{mod}$ sowie der gemessene Strom I$_{mess}$ zugeführt wird.

Wesentliche Eigenschaft der Erfindung ist, dass das dynamische Modell spannungsgeführt arbeitet, d.h. mit der gemessenen Spannung U$_{mess}$ als Eingangsgröße. Der für den Anwender zu übergebende Ladezustand ergibt sich direkt aus dem Modell. Das Übergeben kann beispielsweise mittels einer Anzeigeeinheit erfolgen.

Die Genauigkeit des Verfahrens ist stark davon abhängig, wie genau das Modell aus der gegebenen Spannung den tatsächlichen SOC und die Stromstärke I$_{mess}$ der realen Batterie wiedergeben kann, d.h. wie gut SOC$_{mod}$ und SOC bzw. I$_{mess}$ und I$_{mod}$ übereinstimmen. Zur Erhöhung der Genauigkeit können dem Modell zusätzlich eine gemessene Temperatur T$_{mess}$ der Zelle oder der Umgebung $T_{mess}^{umg}$ oder andere Messgrößen übergeben werden.

Wie in Fig. 2 dargestellt, lässt sich dieser Gesamt-Algorithmus 100 auf einfache Weise in ein bestehendes Batteriemanagementsystem integrieren. Hierzu muss in dem Batteriemanagementsystem (nicht dargestellt) lediglich eine Vorrichtung 108 zur Durchführung des Verfahrens enthalten sein. Die Vorrichtung 108 umfasst eine Einheit 110 zur Messung der Batteriespannung U$_{mess}$, die mit den Anschlüssen (Polen) der Batterie 106 verbunden ist. Weiterhin umfasst die Vorrichtung 108 eine Einheit 112 zur Messung des Batteriestroms I$_{mess}$, die in beliebiger Weise ausgebildet sein kann. Beispielsweise kann die Einheit 112 einen Shunt-Widerstand umfassen, der im Strompfad zwischen den Batteriepolen und einer beliebigen Last R$_L$ liegt, die auch mit dem Bezugszeichen 114 bezeichnet ist. Die Einheit 112 kann dabei zur Messung der Spannung über den Shunt-Widerstand und zur Berechnung des Stroms aus dem gemessenen Spannungsabfall und dem Widerstandswert des Shunt-Widerstands ausgebildet sein.

Die Vorrichtung 108 kann auch eine Anzeigeeinheit 116 umfassen, auf welcher die ermittelten Werte für den SOC bzw. SOH angezeigt werden. Die Vorrichtung 108 umfasst zur Durchführung der für die Realisierung des Verfahrens erforderlichen Berechnungen eine Recheneinheit 118, die beispielsweise als Mikroprozessoreinheit ausgebildet sein kann. Die Mikroprozessoreinheit kann dabei auch einen Analog/DigitalWandler aufweisen, der ihr zugeführte analoge Größen U$_{mess}$ und I$_{mess}$ zeitlich abtastet und in digitale Werte umsetzt.

Im Folgenden werden nunmehr das Grundprinzip des erfindungsgemäßen Verfahrens sowie spezielle Varianten näher erläutert.

Das Batteriemodell hat zwei Mindestanforderungen. Erstens muss es dynamisch sein, d.h. es muss mindestens eine zeitabhängige Zustandsgröße geben. Dies ist typischerweise die restliche Ladungsmenge Q bzw. der Ladezustand $SOC = \dfrac{Q}{C_N}$, die sich zeitlich aufgrund einer angelegten Stromstärke ändern. Zweitens muss der Verlauf der Spannung als Funktion von Ladezustand und Stromstärke beschrieben werden.

In einer allgemeinen Darstellung besteht das Modell somit aus zwei Gleichungen,

$$\frac{dSOC_{mod}}{dt} = -\frac{I_{mod}}{C_N} \tag{1}$$

$$U_{mess} = U^0(SOC_{mod}, T_{mess}, t) + \eta(I_{mod}, SOC_{mod}, T_{mess}, t) \tag{2}$$

Die beiden Gleichungen beschreiben implizit das zeitliche Verhalten der beiden gesuchten Unbekannten (SOC$_{mod}$, I$_{mod}$) als Funktion der gemessenen Eingangsgröße U$_{mess}$ bei gegebenen Parametern und Batterieeigenschaften ($C_N$, $U^0$, $\eta$).

Die beiden Terme auf der rechten Seite der zweiten Gleichung repräsentieren die Leerlaufspannung $U^0$ sowie die Überspannung $\eta$, d.h. Spannungsabfälle aufgrund langsamer innerer Vorgänge wie Reaktionen und Transport. Die Leerlaufspannung $U^0$ ist hauptsächlich vom SOC abhängig, mit weiteren möglichen Abhängigkeiten von der Temperatur und der zeitlichen Lade-/Entladehistorie (z.B. bei Batteriematerialien mit Hysterese wie Lithiumeisenphosphat). Die Überspannung ist abhängig vom SOC, der Stromstärke I$_{mod}$ und der Temperatur T$_{mess}$ und hat außerdem einen ausgeprägten dynamischen (zeitlichen) Verlauf aufgrund elektrochemischer Doppelschichten. Zur Beschreibung des Verhaltens von $U^0$ und $\eta$ können je nach Modellkomplexität weitere Modellgleichungen verwendet werden. Hier und im Folgenden wird das Vorzeichen des Batteriestroms (gemessen und berechnet) im Fall der Entladung der Batterie positiv gewählt, d.h. $I > 0$, und im Fall der Ladung der Batterie negativ, d.h. $I < 0$.

Die Lösung des impliziten Gleichungssystems (1) und (2) nach SOC$_{mod}$ und I$_{mod}$ erfordert eine Invertierung. Dies kann, je nach Modell oder Implementierung, analytisch oder numerisch geschehen. Die Lösung wird beispielhaft in den unten angeführten Beispielen gezeigt, es sind jedoch auch andere Methoden denkbar.

Eine mögliche Realisierung des Verfahrens bietet die Verwendung eines realen (z.B. gemessenen) Zusammenhangs zwischen Leerlaufspannung U$^0$ und SOC, $U^0 = U^0(SOC)$, der Annahme eines konstanten Innenwiderstands $R_i$, aus dem sich die Überspannung zu $\eta = -R_i \cdot I_{mod}$ ergibt, und der Annahme einer Temperaturunabhängigkeit. Damit vereinfacht sich das Gleichungssystem (1) und (2) zu

$$\frac{\mathrm{dSOC_{mod}}}{\mathrm{d}t} = -\frac{I_{\mathrm{mod}}}{C_N} \tag{3}$$

$$U_{\mathrm{mess}} = U^0(\mathrm{SOC_{mod}}) - R_{\mathrm{i}} \cdot I_{\mathrm{mod}} \quad . \tag{4}$$

Der Zusammenhang $U^0(\mathrm{SOC_{mod}})$ kann entweder tabellarisch (z.B. Messwerte) oder in Form einer analytischen Funktion angegeben werden. Dieses Modell wird im Folgenden als "Modell A" oder "Einfaches Modell" bezeichnet. Das Gleichungssystem (3) und (4) ist hinreichend einfach, so dass es analytisch invertiert werden kann. Dazu wird Gleichung (4) nach $I_{\mathrm{mod}}$ aufgelöst und die erhaltene Beziehung in Gleichung (3) eingesetzt. Es ergibt sich

$$\frac{\mathrm{dSOC_{mod}}}{\mathrm{d}t} = -\frac{1}{R_{\mathrm{i}} \cdot C_N}(U^0(\mathrm{SOC_{mod}}) - U_{\mathrm{mess}}) \tag{5}$$

$$I_{\mathrm{mod}} = \frac{1}{R_{\mathrm{i}}}(U^0(\mathrm{SOC_{mod}}) - U_{\mathrm{mess}}) \tag{6}$$

mit $U_{\mathrm{mess}}$ als unabhängige (gegebene) Variable, $\mathrm{SOC_{mod}}$ und $I_{\mathrm{mod}}$ als abhängige (gesuchte) Variablen, und $U^0(\mathrm{SOC})$, $R_i$ und $C_N$ als Modellparameter.

In einem realen System werden Spannungsmesswerte i.d.R. in Form von diskreten Werten $U^i_{\mathrm{mess}}$ in einem gegebenen zeitlichen Abstand $\Delta t$ gemessen. Hier ist $i$ der Index für einen Zeitschritt. Zur Lösung des Gleichungssystems (5) und (6) ist daher eine Zeitdiskretisierung notwendig. Eine Diskretisierung nach der expliziten Vorwärts-Euler-Methode ergibt die folgende Lösung:

$$\mathrm{SOC_{mod}^{i+1}} = \mathrm{SOC_{mod}^i} - \frac{\Delta t}{R_i \cdot C_N}\left(U^0\left(\mathrm{SOC_{mod}^i}\right) - U^i_{\mathrm{mess}}\right) \tag{7}$$

$$I_{\mathrm{mod}}^i = \frac{1}{R_i}\left(U^0\left(\mathrm{SOC_{mod}^i}\right) - U^i_{\mathrm{mess}}\right) \tag{8}$$

Gleichung (7) bildet eine konkrete Rechenvorschrift für die neue Methode zur SOC-Bestimmung. Einzige Eingangsgröße ist der aktuelle Spannungs-Messwert $U^i_{\mathrm{mess}}$. Als gespeicherter Wert ist lediglich der im vorigen Schritt berechnete $\mathrm{SOC_{mod}^i}$ nötig. Der berechnete neue Wert $\mathrm{SOC_{mod}^{i+1}}$ wird dem Nutzer als aktueller SOC der Batterie weitergegeben. Diese Bestimmung des SOC aus Gleichung (7) ist somit extrem einfach und kann mit geringer Rechenleistung in kurzer Zeit durchgeführt werden. Sie kann problemlos auf einem Mikrocontroller implementiert werden, da nur einfache Rechenschritte notwendig sind. Auch der Messaufwand ist gering, es muss lediglich die Spannung $U_{\mathrm{mess}}$ in Form von zeitdiskreten Spannungswerten $U^i_{\mathrm{mess}}$ gemessen werden. Eine Messung der Stromstärke ist, anders als bei herkömmlichen Verfahren zur SOC-Bestimmung, nicht erforderlich.

Gleichung (8) liefert parallel die zugehörige Stromstärke $I_{\mathrm{mod}}^i$. Für die SOC-Bestimmung wird diese nicht benötigt, wohl aber für die SOH-Bestimmung (siehe unten).

Die Gleichungen (7) und (8) wurden aus Gleichungen (5) und (6) durch eine explizite Vorwärts-Euler-Diskretisierung hergeleitet. Es gibt auch alternative Diskretisierungsmethoden. Eine implizite Rückwärts-Euler-Diskretisierung ist zwar aufgrund des nichtlinearen Zusammenhangs $U^0(\mathrm{SOC_{mod}})$ nicht geschlossen möglich, hier wären weitere numerische Verfahren notwendig (z.B. Newton-Verfahren). Einen Spezialfall bildet jedoch die Annahme eines linearen Zusammenhangs zwischen Spannung und SOC nach der Beziehung $U^0 = (U_L - U_E) \cdot \mathrm{SOC} + U_E$, wobei mit $U_L$ die Ladeschlussspannung und mit $U_E$ die Entladeschlussspannung bezeichnet ist. Damit vereinfachen sich Gleichungen (5) und (6) weiter zu

$$\frac{\mathrm{dSOC_{mod}}}{\mathrm{d}t} = -\frac{1}{R_i \cdot C_N}\left((U_L - U_E) \cdot \mathrm{SOC_{mod}} + U_E - U_{\mathrm{mess}}\right) \tag{9}$$

$$I_{\text{mod}} = \frac{1}{R_i}\left((U_L - U_E)\cdot \text{SOC}_{\text{mod}} + U_E - U_{\text{mess}}\right) \tag{10}$$

Die Rückwärts-Euler-Diskretisierung liefert folgendes Ergebnis:

$$I_{\text{mod}}^{i+1} = \frac{1}{\frac{(U_L - U_E)}{C_N}\Delta t + R_i}\left((U_L - U_E)\cdot \text{SOC}_{\text{mod}}^i + U_E - U_{\text{mess}}^{i+1}\right) \tag{11}$$

$$\text{SOC}_{\text{mod}}^{i+1} = \text{SOC}_{\text{mod}}^i - \frac{I_{\text{mod}}^{i+1}}{C_N}\Delta t \tag{12}$$

Auch in diesem Fall ist die Rechenvorschrift sehr einfach. Diese Form ist zudem numerisch stabiler. Allerdings würden die Ergebnisse sehr unter der stark vereinfachten und unrealistischen linearen $U^0(\text{SOC}_{\text{mod}})$-Beziehung leiden. Für hinreichend kleine Zeitschritte $\Delta t \leq 10$ s haben Berechnungen jedoch keinen signifikanten Unterschied zwischen expliziter und impliziter Diskretisierung gezeigt.

Selbstverständlich sind auch andere analytisch angegebene $U^0(\text{SOC})$-Beziehungen denkbar. Je nach analytischer Form kann das Gleichungssystem (5) und (6) analytisch oder mit geeigneten numerischen Verfahren gelöst werden.

Im Folgenden wird beispielhaft ein komplexes, auch als Modell B bezeichnetes Batteriemodell und dessen Verwendung zur SOC- bzw. SOH-Bestimmung erläutert. Reale Batterien haben ein kompliziertes dynamisches Strom-Spannungs-Temperatur-Verhalten, das mit dem einfachen Modell der Gleichungen (5) und (6) nicht vollständig abgebildet werden kann. Zur Erhöhung der Zuverlässigkeit des Verfahrens können daher auch kompliziertere Modelle eingesetzt werden.

Im Folgenden wird das in Fig. 3 gezeigte Äquivalenzschaltkreismodell betrachtet. Es handelt sich um ein elektrisch-thermisches Modell. Das elektrische Modell besteht aus der Leerlauf-Spannungsquelle $U^0(\text{SOC})$, einem seriellen Widerstand $R_s$ sowie zwei Widerstands-Kondensator-(RC)-Elementen ($R_{\text{CT}}$ und $C_{\text{DL}}$, jeweils eines für die beiden Elektroden Anode und Kathode). Es sind außerdem Elemente zugefügt, die eine Asymmetrie der Leerlaufspannung beschreiben ($\Delta U_{\text{hys}}$) und eine Lade-/Entladeasymmetrie des Kathodenwiderstands. Damit ist das Modell geeignet, eine Lithiumeisenphosphat(LFP)/Graphit Lithium-Ionen-Zelle abzubilden (Siehe H. Kim, "Modeling an parameterization of a commercial LFP/Graphite Lithium-ion cell considering charge and discharge characteristics", Masterarbeit, Hochschule Offenburg, 2018), die diese Asymmetrien zeigt. Das thermische Modell besteht aus Wärmequellen und einem Wärmeübergang an die Umgebung. Alle Parameter werden außerdem temperaturabhängig angenommen.

Das Äquivalenzschaltkreismodell lässt sich in folgendes differenziell-algebraische Gleichungssystem abbilden:

$$\frac{d\text{SOC}_{\text{mod}}}{dt} = -\frac{I_{\text{mod}}}{C_N} \tag{13}$$

$$U_{\text{mess}} = U^0(\text{SOC}_{\text{mod}}, T_{\text{mod}}) + \Delta U_{\text{hys}}(I_{\text{mod}}) - U_{\text{RC,an}} - U_{\text{RC,ca}} - I_{\text{mod}}\cdot R_s(T_{\text{mod}}) \tag{14}$$

$$\frac{dU_{\text{RC,an}}}{dt} = \frac{1}{C_{\text{DL,an}}(T_{\text{mod}})}\left(I_{\text{mod}} - \frac{U_{\text{RC,an}}}{R_{\text{CT,an}}(T_{\text{mod}})}\right) \tag{15}$$

$$\frac{dU_{\text{RC,ca}}}{dt} = \frac{1}{C_{\text{DL,ca}}(T_{\text{mod}})}\left(I_{\text{mod}} - \frac{U_{\text{RC,ca}}}{R_{\text{CT,ca}}(T_{\text{mod}}, I_{\text{mod}})}\right) \tag{16}$$

$$\frac{dT_{\text{mod}}}{dt} = \frac{1}{C_{\text{th}}}\left(I_{\text{mod}}^2 R_s(T_{\text{mod}}) + \frac{U_{\text{RC,an}}^2}{R_{\text{CT,an}}(T_{\text{mod}})} + \frac{U_{\text{RC,ca}}^2}{R_{\text{CT,ca}}(T_{\text{mod}}, I_{\text{mod}})} - \frac{T_{\text{mod}} - T_{\text{mess}}^{\text{umg}}}{R_{\text{th}}} + I_{\text{mod}}\cdot\right.$$
$$\left.(T_{\text{mod}} - T^0)\cdot\frac{dU^0(\text{SOC}_{\text{mod}})}{dT}\right) \tag{17}$$

**Hier sind** $U_{\text{RC}}$ der Spannungsabfall über das RC-Element, $R_{\text{CT}}$ der Ladungstransferwiderstand ("charge transfer resistance"), $C_{\text{DL}}$ die Doppelschichtkapazität, $C_{\text{th}}$ die Wärmekapazität, $R_{\text{th}}$ der Wärmeübergangswiderstand an der Batterieoberfläche, $dU^0(\text{SOC}_{\text{Modell}})/dT$ die Temperaturabhängigkeit der Leerlaufspannung, $T^0$ die zugehörige Referenztemperatur, und die Indizes an und ca bedeuten "anode" und "cathode", also die beiden Elektroden. Die Asymmetrie der Leerlaufspannung wird durch $\Delta U_{hys}$ beschrieben, und die Asymmetrie des Kathodenwiderstands durch die Stromabhängigkeit von $R_{CT,ca}$. Durch Vergleich von Gleichungen (13) und (14) mit Gleichungen (1) und (2) ist zu erkennen, dass es sich um eine weitere Form des grundlegenden Modells handelt. Zur Beschreibung werden die zusätzlichen Gleichungen (15) bis (17) benötigt. Nach wie vor beschreiben Gleichungen (13) bis (17) implizit das zeitliche Verhalten der beiden gesuchten Unbekannten ($SOC_{mod}$, $I_{mod}$) als Funktion der gemessenen Eingangsgrößen, nämlich der Spannung $U_{mess}$ und der Umgebungstemperatur $T_{mess}^{umg}$.

Aufgrund der Kopplung der Gleichungen ist eine analytische Lösung nicht möglich. Für die nachstehend erläuterten Simulationsergebnisse wurde ein impliziter numerischer Löser verwendet, der im Softwarepaket MATLAB zur Verfügung gestellt wird. Die Lösung ist aber auch mit anderen Methoden möglich.

Es sei nochmals ausdrücklich darauf hingewiesen, dass die beiden vorgestellten Modelle A und B nur zur Demonstration des neuen Verfahrens dienen, das jedoch in keiner Weise auf diese beiden konkreten Modelle beschränkt ist. Vielmehr sind beliebige einfachere oder noch komplexere Modelle denkbar.

Die oben vorgestellten Modelle (A: "Einfaches Modell" und B: "Äquivalenzschaltkreismodell") können je nach Parametrierung unterschiedliche Batterien bzw. Batterietypen beschreiben. Im Folgenden werden zwei Modelle auf konkrete Lithium-Ionen-Batteriezellen parametriert.

Als exemplarischen Vertreter einer im Bereich der Elektromobilität angewendeten Batterie betrachten wir eine Lithium-Ionen-Batterie mit Nickel-Mangan-Kobaltoxid/Graphit-Chemie (NMC-Graphit), konkret eine Zelle des Herstellers Kokam, Modell SLPB533459H4, mit einer Nennkapazität von 0,74 Ah und einer Nennspannung von 3,7 V. Von dieser Zelle stellen Birkl und Howey ausführliche Datensätze zur freien Verwendung zur Verfügung (Christoph Birkl, David Howey, "Oxford Battery Degradation Dataset 1", University of Oxford, DOI: 10.5287/bodleian:KO2kdmYGg, Webseite: https://ora.ox.ac.uk/objects/uuid:03ba4b01-cfed-46d3-9b1a-7d4a7bdf6fac (2017)), die sich hervorragend für die Demonstration des vorliegenden Verfahrens eignen.

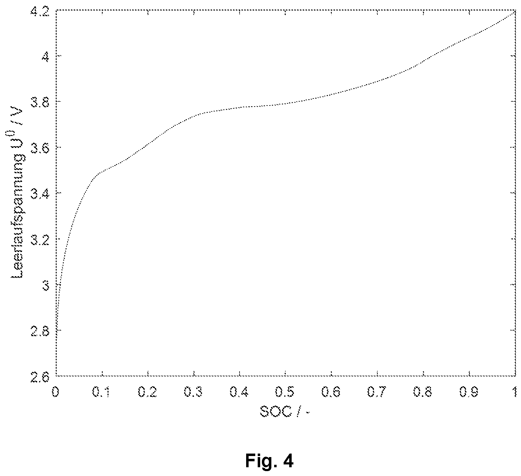

Das Modell A ("Einfaches Modell") wird auf diese Zelle wie folgt parametriert: Die Leerlaufspannungskurve $U^0$(SOC) wurde ermittelt, indem der Mittelwert einer Lade- und einer Entladekennlinie, die mit jeweils 40 mA aufgenommen wurden ("Quasi-Leerlaufspannung"), gebildet wurde. Die Kapazität wurde auf das Maximum normiert. Die so erhaltene $U^0$(SOC)-Beziehung ist in Fig. 4 dargestellt. Die Nennkapazität $C_N$ = 0,74 Ah wurde direkt von der Herstellerangabe übernommen. Der Innenwiderstand wurde bestimmt, indem die Zellladespannungen bei jeweils 50 % SOC für Entladungen mit 40 mA und 740 mA aus den Experimenten abgelesen wurden, es ergibt sich $R_i$ =

$$-\frac{U(40\text{ mA})-U(740\text{ mA})}{40\text{ mA}-740\text{ mA}} = 0{,}0464\ \Omega$$

. Die Parameter werden temperaturunabhängig ange-nommen. Die vollständige Parametrierung benötigt damit nur zwei experimentelle Lade-/Entladekennlinien (bei 40 mA und 740 mA).

Als exemplarischer Vertreter einer im Bereich der stationären Stromspeicher (Heimspeicher, Gewerbespeicher, Speicher für Netzanwendungen, unterbrechungsfreie Stromversorgung) angewendeten Zellchemie wird im Folgenden eine Lithium-Ionen-Batterie mit Lithiumeisenphophat/Graphit-Chemie (LFP-Graphit) betrachtet, konkret eine Zelle des Herstellers Sinopoly, Modell SP-LFP180AHA mit einer Nennkapazität von 180 Ah und einer Nennspannung von 3,2 V. Diese Zelle wurde an der Hochschule Offenburg charakterisiert (siehe H. Kim, a.a.O).

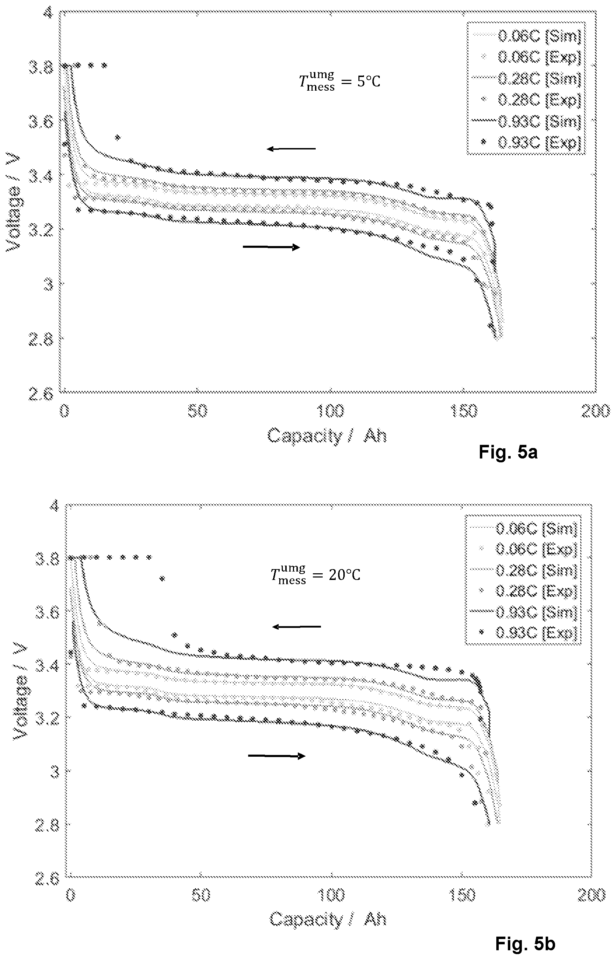

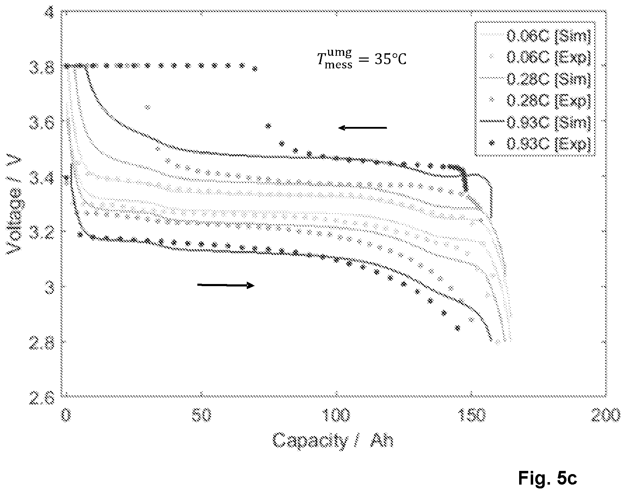

Für dieses Beispiel wurde das Modell B (Äquivalenzschaltkreismodell) auf diese konkrete Zelle parametriert. Fig. 5 zeigt simulierte Entlade-Lade-Kennlinien (Zellspannung gegenüber Ladungsmenge) nach erfolgreicher Parametrierung bei drei Temperaturen (5°C, 20°C und 35°C) und drei Stromstärken, wobei die Stromstärken mit der Einheit der C-Rate angegeben sind (d.h. im vorliegenden Fall beträgt 1C=180 A). Die Pfeile zeigen dabei die Richtung an, in welcher die Kurven durchlaufen werden, als die Entladerichtung (Pfeil nach rechts) und die Laderichtung (Pfeil nach links). Die jeweils obere der zusammengehörenden Kurven ist dabei jeweils die Ladekurve und die untere die Entladekurve. Die am dunkelsten dargestellten Kurven (ganz oben und ganz unten) sind die Lade- und Entladekurven für einen Strom von 0.93 C, und die obere und untere der innersten Kurven (am hellsten dargestellt) sind die Lade- und Entladekurven für einen Strom von 0,06 C. Die zwischen diesen Kurven liegenden Kurven sind die Lade- und Entladekurven für einen Strom von 0,28 C. Die Punkte der Kurven stellen Messwerte da und die durchgezogenen Linien die Simulationswerte. Wie aus Fig. 5 ersichtlich, können die gemessenen Werte einschließlich der Asymmetrie und Hysterese der Experimente sehr gut vom Modell über den gesamten Bereich vorhergesagt werden.

Im Folgenden wird die Bestimmung des SOH mittels des SOH-Algorithmus näher erläutert. Dessen konkrete Anwendung setzt ebenfalls die vorstehend erläuterte Parametrierung des verwendeten dynamischen mathematischen Batteriemodells voraus.

Die oben dargestellten Batteriemodelle sind in der Lage, zusätzlich zum Ladezustand $SOC_{mod}$ auch die Stromstärke $I_{mod}$ als Ausgangsgröße zur Verfügung zu stellen. Zusätzlich zur Stromstärke nach dem Modell wird die gemessene Stromstärke $I_{mess}$ zur SOH-Bestimmung benötigt. Der SOH-Algorithmus ist in der Lage, aus $I_{mod}$ und $I_{mess}$ den Gesundheitszustand SOH zu berechnen.

Der Algorithmus beruht darauf, dass das Batteriemodell als "digitaler Zwilling" die gleichen Zyklierungen durchführt wie die reale Batterie, da es (wie oben erläutert) mit der gleichen Spannung betrieben wird wie die reale

**EP 4 045 925 B1**

Batterie. Allerdings altert das Batteriemodell - im Gegensatz zur realen Batterie - nicht. Aus dem Unterschied zwischen $I_{mod}$ (ohne Kapazitätsverlust) und $I_{mess}$ (mit Kapazitätsverlust) kann daher der SOH bestimmt werden. Dafür kommen Ladungsmengenzähler zum Einsatz, d.h. es erfolgt eine Integration des gemessenen Stroms $I_{mess}$ und des mittels des Modells ermittelten Stroms $I_{mod}$. Diese Berechnung ist im Folgenden dargestellt.

Wie vorstehend erläutert, ist ein spannungsgeführtes Batteriemodell Voraussetzung für den Algorithmus, denn nur dann ist $I_{mod}$ eine Ausgangsgröße, die mit $I_{mess}$ verglichen werden kann. Das neue Verfahren zur SOH-Bestimmung ist also eng mit dem neuen Verfahren zur SOC-Bestimmung verknüpft.

Für eine vollständige Batterieentladung (voll nach leer), die zum Zeitpunkt $t_0$ beginnt und zum Zeitpunkt $t_l$ abgeschlossen ist, kann ein $SOH_{out}$ definiert werden durch die Beziehung:

$$SOH_{out} = \frac{\int_0^{t_l} I_{bat,akt}\, dt}{\int_0^{t_l} I_{bat,n}\, dt} \qquad (18)$$

wobei mit $I_{bat,n}$ der Batteriestrom einer neuen (nicht gealterten Batterie) bezeichnet ist und mit $I_{bat,akt}$ der Batteriestrom der gealterten Batterie.

Unter der Annahme, dass $I_{bat,akt}$ dem gemessenen Strom der realen Batterie (mit Kapazitätsverlust) entspricht und $I_{bat,n}$ dem simulierten Strom aus dem Batteriemodell (ohne Kapazitätsverlust), kann der $SOH_{out}$ dargestellt werden als:

$$SOH_{out} = \frac{\int_0^{t_l} I_{mess}\, dt}{\int_0^{t_l} I_{mod}\, dt} \qquad (19)$$

Analog hierzu kann auch ein $SOH_{in}$ während einer vollständigen Batterieladung definiert werden, wenn von einer leeren Batterie ausgegangen wird:

$$SOH_{in} = \frac{\int_0^{t_v} I_{mess}\, dt}{\int_0^{t_v} I_{mod}\, dt} \qquad (20)$$

wobei hier angenommen wird, dass der Ladevorgang zum Zeitpunkt $t_0$ beginnt und zum Zeitpunkt $t_V$ abgeschlossen ist.

In der Praxis gibt es nur selten vollständige Lade- und Entladevorgänge (z.B. wird die Batterie eines Elektroautos niemals vollständig entleert werden, da es dann nicht mehr funktionsfähig wäre). Der Algorithmus muss also in der Lage sein, auch mit Teilladungen und -Entladungen den SOH ermitteln zu können. Wir definieren dafür einen beliebigen Zeitraum $[t_1; t_2]$ ohne a priori Wissen, ob es sich in diesem Zeitraum um eine Ladung, eine Entladung oder beides (z.B. einer oder mehrere volle Zyklen oder Teilzyklen) handelt. Der Zeitraum $[t_1; t_2]$ liegt typischerweise im Bereich von Stunden; die genaueren Anforderungen sind weiter unten angegeben. Innerhalb des Zeitraums können wir den SOH berechnen als

$$SOH_{out} = \frac{\int_{t_1}^{t_2} I_{mess,out}\, dt}{\int_{t_1}^{t_2} I_{mod,out}\, dt} \quad \text{und} \qquad (21)$$

$$SOH_{in} = \frac{\int_{t_1}^{t_2} I_{mess,in}\, dt}{\int_{t_1}^{t_2} I_{mod,in}\, dt}, \qquad (22)$$

wobei die Indizes "out" und "in" bei den Strömen eine Entladung (out) bzw. eine Ladung (in) der Batterie bezeichnen. In diesen Gleichungen ist

$$I_{mess,in} = \begin{cases} |I_{mess}| & \text{für } I_{mess} < 0 \\ 0 & \text{für } I_{mess} \geq 0 \end{cases} \qquad (23)$$

$$I_{mess,out} = \begin{cases} 0 & \text{für } I_{mess} < 0 \\ |I_{mess}| & \text{für } I_{mess} \geq 0 \end{cases} \text{bzw.} \qquad (24)$$

12

$$I_{\mathrm{mod,in}} = \begin{cases} |I_{\mathrm{mod}}| \text{ für } I_{\mathrm{mod}} < 0 \\ 0 \text{ für } I_{\mathrm{mod}} \geq 0 \end{cases} \qquad (23)$$

$$I_{\mathrm{mod,out}} = \begin{cases} 0 \text{ für } I_{\mathrm{mod}} < 0 \\ |I_{\mathrm{mod}}| \text{ für } I_{\mathrm{mod}} \geq 0 \end{cases} \qquad (24)$$

In Gleichung (21) wird also nur bei Entladung integriert, in Gleichung (22) nur bei Ladung. Grundsätzlich könnte jeder dieser SOH-Werte, d.h. $SOH_{out}$ oder $SOH_{in}$, bereits als Näherungswert für den tatsächlichen SOH dienen. Eine Steigerung der Genauigkeit kann jedoch durch eine Mittelwertbildung erzielt werden gemäß der Beziehung

$$SOH = \frac{SOH_{\mathrm{out}} + SOH_{\mathrm{in}}}{2} \qquad (25)$$

Der Zeitraum $[t_1; t_2]$ ist zunächst beliebig; die Wahl des Zeitraums beeinflusst jedoch die Genauigkeit des Verfahrens. In einer konkreten Realisierung des Verfahrens kann dieser Zeitraum vorzugsweise unter Berücksichtigung der folgenden Bedingungen gewählt werden:

- Die während des Zeitraums entladenen und eingeladenen Ladungsmengen müssen größer als ein vordefinierter Schwellenwert $Q_s$ sein (z.B. $C_N$ oder ein Vielfaches von $C_N$).

- Zu Beginn und Ende des Zeitraums herrscht jeweils der gleiche Ladezustand $SOC_{ref}$ (z.B. 50 %).

- Zu Beginn und Ende des Zeitraums herrscht gleiche Stromrichtung (z.B. Batterie befindet sich am Laden).

- Es können auch unterschiedliche, überlappende Zeiträume für die beiden Größen $SOH_{out}$ und $SOH_{in}$ verwendet werden. Dies wird beispielsweise in der im Folgenden dargestellten Realisierung des Verfahrens eingesetzt.

Dieses Verfahren hat den Vorteil, dass, anders als bei herkömmlichen Verfahren, weder die experimentelle Durchführung von Vollzyklen noch ein Algorithmus zum Zählen von Zyklen notwendig sind.

In einer konkreten Realisierung als auf einem Mikrocontroller lauffähiger Programmcode kann der Algorithmus so ausgebildet sein, dass er vier Ladungszähler ($Q_{out,mess}$, $Q_{out,mod}$, $Q_{in,mod}$, $Q_{in,mod}$) und zwei SOH-Werte ($SOH_{out}$, $SOH_{in}$) bestimmt und jeweils speichert. Der Algorithmus wird periodisch nach einem Zeitraum $\Delta t$ aufgerufen; dieser Zeitraum ist idealerweise der gleiche wie bei der SOC-Berechnung. Der Wert für $I_{mod}$ wird jeweils aus dem SOC-Algorithmus erhalten. Es läuft dann folgende Logik ab:

1. Ladungszähler

    (a) Ist

$$I_{\mathrm{mod}} < 0 \text{ (Entladung)?}$$

    Ja

$$: Q_{\mathrm{out,mod}} = Q_{\mathrm{out,mod}} - I_{\mathrm{mod}} \cdot \Delta t$$

    (b) Ist

$$I_{\mathrm{mod}} > 0 \text{ (Ladung)?}$$

$$\text{Ja: } Q_{\mathrm{in,mod}} = Q_{\mathrm{in,mod}} + I_{\mathrm{mod}} \cdot \Delta t$$

    (c) Ist

$$I_{\mathrm{mess}} < 0 \text{ (Entladung)?}$$

Ja:

$$Q_{\text{out,mess}} = Q_{\text{out,mess}} - I_{\text{mess}} \cdot \Delta t$$

(d) Ist

$$I_{\text{mess}} > 0 \text{ (Ladung)}?$$

Ja:

$$Q_{\text{in,mess}} = Q_{\text{in,mess}} + I_{\text{mess}} \cdot \Delta t$$

2. SOH-Berechnung

(a) Sind $Q_{\text{out,mod}} > Q_s$ und $Q_{\text{out,mess}} > Q_s$ und $SOC_{\text{mod}} = SOC_{\text{ref}}$ und ist die Batterie am Entladen?
Ja:

$$SOH_{\text{out}} = \frac{Q_{\text{out,mess}}}{Q_{\text{out,mod}}}$$

Setze $Q_{\text{out,mess}}$ und $Q_{\text{out,mod}}$ auf Null zurück.

(b) Sind $Q_{\text{in,mod}} > Q_s$ und $Q_{\text{in,mess}} > Q_s$ und $SOC_{\text{mod}} = SOC_{\text{ref}}$ und ist die Batterie am Laden?
Ja:

$$SOH_{\text{in}} = \frac{Q_{\text{in,mess}}}{Q_{\text{in,mod}}}$$

Setze $Q_{\text{in,mess}}$ und $Q_{\text{in,mod}}$ auf Null zurück.

(c)

$$SOH = \frac{SOH_{\text{out}} + SOH_{\text{in}}}{2}$$

Der zuletzt berechnete Wert SOH wird vom Algorithmus zurückgegeben und kann z.B. dem Benutzer angezeigt werden. Die Parameter $Q_s$ und $SOC_{\text{ref}}$ beeinflussen die Performanz der SOH-Diagnostik; in den unten gezeigten Beispielen wurde $Q_s = C_N$ und $SOC_{\text{ref}} = 50 \%$ verwendet.

Das Verfahren wird im Folgenden anhand einer Lithium-Ionen-Batteriezelle mit NMC-Graphit-Chemie (repräsentativ für den Anwendungsbereich Elektromobilität) demonstriert. Es werden dazu frei verfügbare experimentelle Daten von Birkl (a.a.O.) verwendet. Es wird das Modell A ("Einfaches Modell") verwendet.

Die Experimente von Birkl (a.a.O.) wurden wie folgt durchgeführt: Die testende Batterie wurde eine Vielzahl von aufeinanderfolgenden Zyklen unterzogen bis die Lebensdauer der Batterie erreicht war, wobei die Batterie in jedem Zyklus mit dem CCCV (Constant Current Constant Voltage) Verfahren geladen und unter Verwendung eines dynamischen Lastprofils, das einen Fahrzyklus in einer Stadt nachbildet, entladen wurde. Nach jedem 100 Zyklus wurde ein Messzyklus zur Charakterisierung der Batterieeigenschaften durchgeführt, wobei die Batterie bzw. eine Batteriezelle mit konstanter Stromstärke von 0,74 A bis zu einer Schlussspannungen 2,7 V entladen und wieder bis zu einer Schlussspannung von 4,2 V geladen wurde. Dieser Charakterisierungsvorgang wurde etwa 80 Mal wiederholt. Veröffentlicht sind jedoch nur die vollen Entlade-/Ladezyklen der Charakterisierungszyklen. Diese wurden für die vorliegende Demonstration zusammengefügt und repräsentieren damit ein beschleunigtes Alterungsverhalten. Gleichzeitig wird damit eine weitere Stärke des neuen Verfahrens aufgezeigt, nämlich die Fähigkeit, zu einem beliebigen Zeitpunkt in den Batteriebetrieb einsteigen zu können und auch mit unvollständigen Daten umgehen zu können.

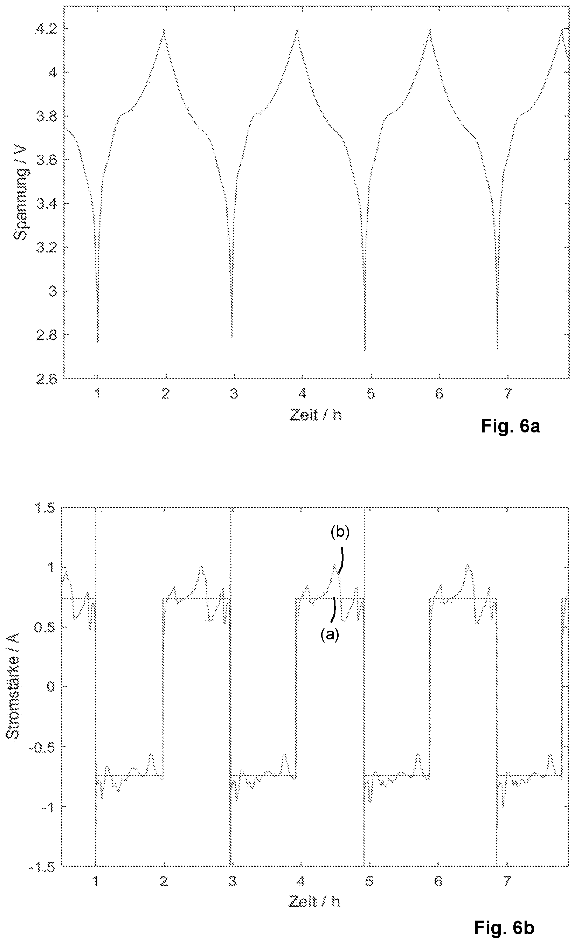

Fig. 6 zeigt die gemessenen bzw. berechneten Größen für das Verfahren unter Verwendung des einfachen Modells (Modell A), nämlich in Fig. 6a die gemessene Spannung und in Fig. 6b die gemessene $I_{\text{mess}}$ Stromstärke (Kurve (a)) bzw. berechnete $I_{\text{mod}}$ Stromstärke (Ausgangsgröße des Modells, Eingangsgröße für den SOH-Algorithmus; Kurve (b)) der Batterie. Der erkennbare Unterschied zwischen Modell und Messung ist eine Folge aus noch vorhandenen Defiziten des verwendeten Modells. Dennoch können aussagekräftige Ergebnisse erhalten werden, wie im Folgenden dargestellt wird.

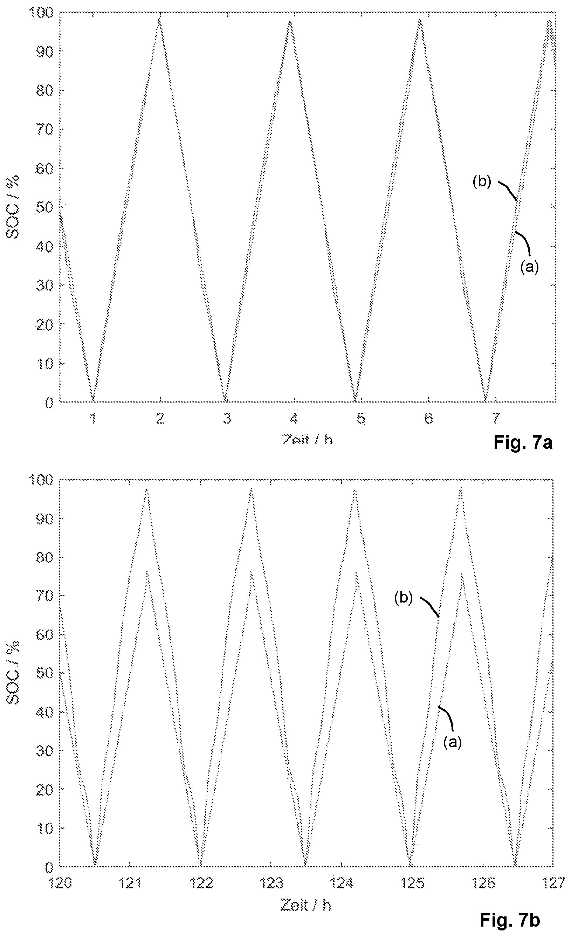

Fig. 7 zeigt den nach dem neuen Verfahren (in der speziellen Ausgestaltung gem. Gleichung (7)) bestimmten Ladezustand SOC für diese Batterie (Kurven (b)). Es ist außerdem ein SOC-Wert gezeigt, der nach herkömmlichen Verfahren basierend auf Ladungszählung (normiert auf die vollständig entladene Zelle) ermittelt wurde (Kurven (a)). Fig. 7a zeigt die ersten Stunden der Zyklierung. Das neue Verfahren kann den SOC mit sehr guter Genauigkeit (im Vergleich zum herkömmlichen Verfahren) bestimmen. Fig. 7b zeigt die letzten Stunden der Zyklierung. Hier ist die Zelle bereits signifikant gealtert, d.h. hat an Kapazität verloren. Das neue Verfahren kann die Vollzyklierung zuverlässig abbilden. Das herkömmliche Verfahren scheitert jedoch an der Alterung der Zelle: Trotz Ladung bis zur Ladeschlussspannung erreicht der SOC im herkömmlichen Verfahren nur einen (inkorrekten) Wert von etwa 75 %. Dieser Vergleich demonstriert die Robustheit des neuen Verfahrens zur SOC-Bestimmung gegenüber Kapazitätsverlust durch Zellalterung.

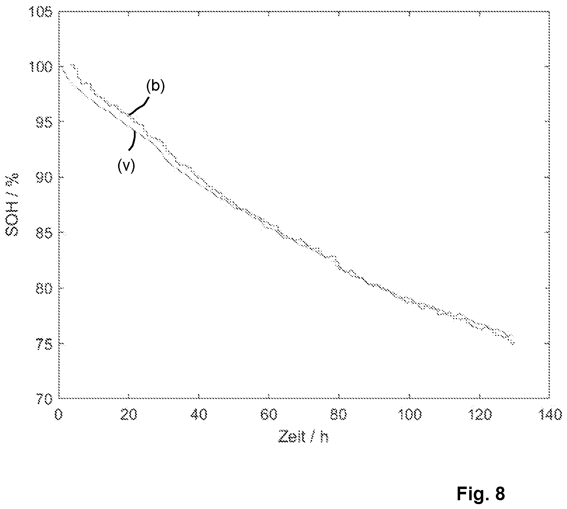

Das Ergebnis der SOH-Bestimmung ist in Fig. 8 dargestellt (Kurve (b)). Außerdem ist ein Vergleich mit Werten aus einer einfachen Ladungszählung nach Gl. (19) dargestellt (Kurve (v)). Die Übereinstimmung ist sehr gut. Aus diesen Ergebnissen folgt, dass sich der SOH mit dem neuen Verfahren zuverlässig bestimmen lässt.

Im Folgenden wird das Verfahren anhand einer Lithium-Ionen-Batteriezelle mit LFP-Graphit-Chemie (repräsentativ für den Anwendungsbereich stationäre Speicher) demonstriert, wobei hierfür das Modell B ("Äquivalenzschaltkreismodell") verwendet wird.

Für die Experimente wurden über 670 konsekutive Lade-/Entladezyklen durchgeführt, wobei das Entladen mit einer konstanten Stromstärke von 150 A und das Laden mit dem CCCV Ladeverfahren erfolgte. Die Entladeschlussspannung betrug 2,85 V und die Ladeschlussspannungen 3,8 V. Die Versuchsdauer betrug ca. 1.500 h. Die Kapazität der neuen Zelle $C_N$ betrug 158 Ah. Mit diesem Datensatz kann sowohl die SOC-Ermittlung (während eines beliebigen Einzelzyklus) als auch die SOH-Ermittlung (über die gesamte Dauer des Versuchs) demonstriert werden. Zusätzlich wurden mit einer geeigneten Messtechnik hochpräzise Werte von SOC und SOH nach dem herkömmlichen Verfahren der Ladungszählung ermittelt, die zum Vergleich mit dem neuen Verfahren dienen.

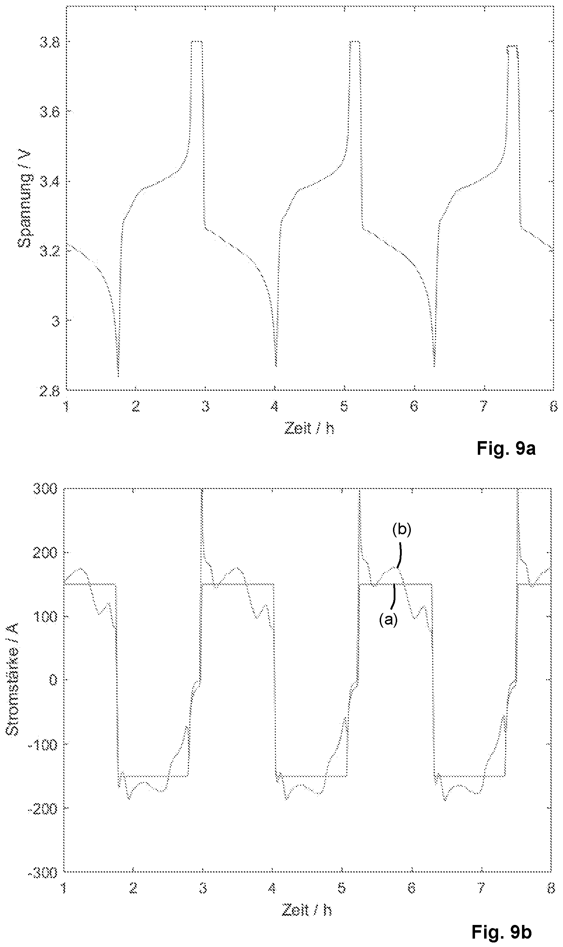

Fig. 9 zeigt die Eingangsgrößen für das Verfahren, d.h. die gemessene Spannung $U_{mess}$ (Fig. 9a) und die gemessene Stromstärke $I_{mess}$ (Fig. 9b; Kurve (a)) für diese Batterie. Fig. 9b zeigt außerdem die modellierte Stromstärke $I_{mod}$ (Ausgangsgröße des Modells und Eingangsgröße für den SOH-Algorithmus; Kurve (b)). Der erkennbare Unterschied zwischen Modell und Messung ist eine Folge aus noch vorhandenen Defiziten des verwendeten Modells.

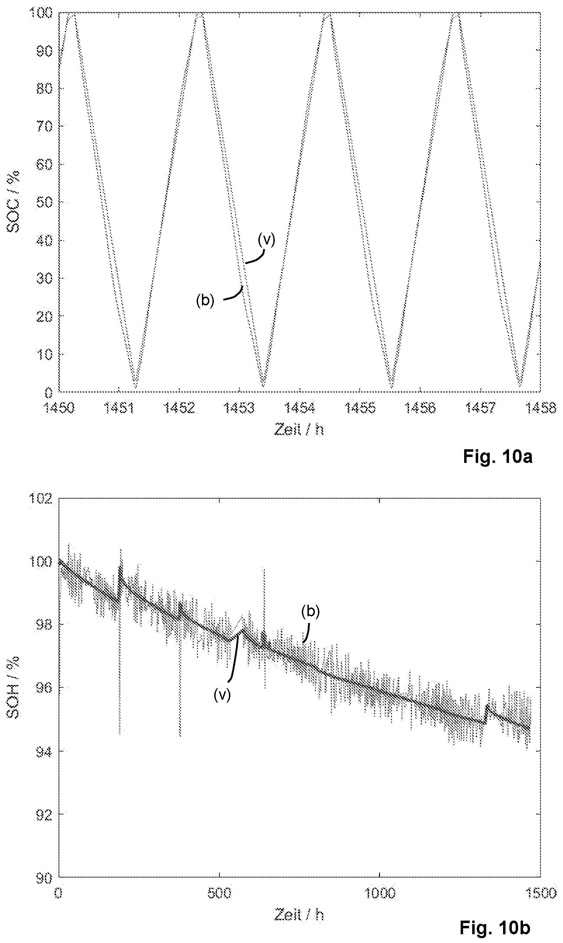

Das Ergebnis des Verfahrens, der Ladezustand SOC und der Gesundheitszustand SOH der Batterie, ist in Fig. 10 dargestellt (Kurven (b)). Zum Vergleich sind außerdem Werte dargestellt, die aus der präzisen Vergleichsmessung resultieren (Kurven (v)). Fig. 10a zeigt den SOC. Das neue Verfahren kann die Zyklierung der Batterie zwischen 0 % und 100 % SOC zuverlässig wiedergeben, wenn auch mit einem gewissen geringen Fehler gegenüber der präzisen Messung. Fig. 10b zeigt den SOH. Das neue Verfahren ist in der Lage, den Kapazitätsverlust der Batterie über die Versuchsdauer von ca. 1.500 Stunden zuverlässig wiederzugeben. Im Vergleich zur präzisen Messung zeigt sich lediglich ein erhöhtes Rauschen.

Diese Ergebnisse belegen die Funktionsfähigkeit des vorstehend beschriebenen Verfahrens zur Bestimmung des Ladezustands und des Gesundheitszustands von Batterien.

Liste wesentlicher Bezeichnungen von Variablen und Parametern

| | |
|---|---|
| C | Kapazität der Batterie |
| $C_N$ | Nennkapazität der Batterie |
| $I_{mess}$ | gemessener Batteriestrom |
| $I_{mod}$ | Modell-Batteriestrom |
| | |
| Q | Restladung in der Batterie |
| SOC | tatsächlicher Ladezustand |
| $SOC_{mod}$ | Ladezustand nach dem Batteriemodell |
| SOH | tatsächlicher Gesundheitszustand |
| $SOH_{mod}$ | Gesundheitszustand nach dem Batteriemodell |
| t | Zeit |
| $T_{mess}$ | gemessene Temperatur der Batterie |
| $T_{mess}^{umg}$ | gemessene Umgebungstemperatur |
| $U_{mess}$ | gemessene Batteriespannung |
| $U_{mod}$ | Modell-Batteriespannung |
| $U^0$ | Leerlaufspannung |
| | |
| $\Delta t$ | Abtastintervall |

Bezugszeichenliste

| | |
|---|---|
| 100 | Gesamt-Algorithmus |
| 102 | erster Bestandteil des Gesamt-Algorithmus |
| 104 | zweiter Bestandteil des Gesamt-Algorithmus |
| 106 | Batterie |
| 108 | Vorrichtung zur Durchführung des Verfahrens |
| 110 | Einheit zu Spannungsmessung |
| 112 | Einheit zur Strommessung |
| 114 | Last |
| 116 | Anzeigeeinheit |
| 118 | Recheneinheit |

**Patentansprüche**

**1.** Verfahren zur Bestimmung des Ladezustandes einer aufladbaren Batterie oder eines damit in einem physikalischen Zusammenhang stehenden Parameters, insbesondere einer in der Batterie enthaltenen Restladungsmenge Q, wobei das Verfahren folgende Schritte umfasst:

(a) Erstellen eines spannungsgeführten dynamischen mathematischen Batteriemodells für die Batterie (106) oder einen vorgegebenen Batterietyp für die Batterie (106),

(i) welches einen Ladezustand der Batterie $SOC_{mod}$ oder den damit in einem physikalischen Zusammenhang stehenden Parameter mit einem Batteriestrom $I_{mod}$ verknüpft, und

(ii) welches eine zwischen den beiden Polen der Batterie (106) gemessene Spannung $U_{mess}$ in Abhängigkeit von einer Summe aus einer Leerlaufspannung $U^0$ der Batterie (106) und einer Überspannung $\eta$ definiert,

(iii) wobei die Leerlaufspannung $U^0$ zumindest von der restlichen Ladungsmenge Q oder dem damit in einem physikalischen Zusammenhang stehenden Parameter und die Überspannung $\eta$ zumindest von dem Batteriestrom $I_{mod}$ abhängt; und

(iv) wobei das spannungsgeführte dynamische mathematische Batteriemodell aus einem impliziten Gleichungssystem besteht oder hieraus entwickelt ist, welches folgende Gleichungen umfasst:

(1)

$$\frac{\mathrm{dSOC_{mod}}}{\mathrm{d}t} = -\frac{I_{\mathrm{mod}}}{C_{\mathrm{N}}}$$

(2)

$$U_{\mathrm{mess}} = U^0(\mathrm{SOC_{mod}}, T_{\mathrm{mess}}, t) + \eta(I_{\mathrm{mod}}, \mathrm{SOC_{mod}}, T_{\mathrm{mess}}, t)$$

wobei mit $C_N$ eine vorgegebenen Nennkapazität der Batterie (106), mit $T_{mess}$ eine gemessene Temperatur der Batterie (106) und mit t die Zeit bezeichnet ist, wobei die Leerlaufspannung $U^0$ zwingend eine Abhängigkeit vom Ladezustand $SOC_{mod}$ zeigt, während die Abhängigkeit von der gemessenen Temperatur $T_{mess}$ und der Zeit t optional ist, und wobei die Überspannung $\eta$ zwingend eine Abhängigkeit vom Batteriestrom $I_{mod}$ zeigt, während die Abhängigkeit vom Ladezustand $SOC_{mod}$ und der Zeit t optional ist.

(b) Parametrieren des spannungsgeführten dynamischen mathematischen Batteriemodells für die Batterie (106) oder den vorgegebenen Batterietyp; und

(c) Bestimmung eines Näherungswertes $SOC_{mod}$ für den tatsächlichen Ladezustand SOC der Batterie (106) oder den damit in einem physikalischen Zusammenhang stehenden Parameter durch Messen der Batteriespannung $U_{mess}$ und Berechnen des Näherungswertes $SOC_{mod}$ unter Verwendung des parametrierten spannungsgeführten dynamischen mathematischen Batteriemodells.

2. Verfahren nach Anspruch 1, **dadurch gekennzeichnet, dass** die Leerlaufspannung $U^0$ als ausschließlich vom Ladezustand $SOC_{mod}$ abhängig vorausgesetzt wird, dass ein konstanter Innenwiderstand $R_i$ der Batterie (106) vorausgesetzt wird und dass eine Temperaturunabhängigkeit des Batteriemodells vorausgesetzt wird, so dass das Batteriemodell durch folgende Gleichungen definiert ist:

(a)

$$\frac{dSOC_{mod}}{dt} = -\frac{I_{mod}}{C_N}$$

(b)

$$U_{mess} = U^0(SOC_{mod}) - R_i \cdot I_{mod},$$

wobei die Abhängigkeit der Leerlaufspannung $U^0$ vom Ladezustand $SOC_{mod}$ insbesondere durch Messung, insbesondere als gemessene diskrete Werte oder als analytische Funktion, ermittelt wird.

3. Verfahren nach Anspruch 2, **dadurch gekennzeichnet, dass** die beiden Gleichungen durch analytische Inversion gelöst werden, wobei der Ladezustand $SOC_{mod}$ aus den Gleichungen

$$\frac{dSOC_{mod}}{dt} = -\frac{1}{R_i \cdot C_N} \cdot (U^0(SOC_{mod}) - U_{mess})$$

$$I_{mod} = \frac{1}{R_i}(U^0(SOC_{mod}) - U_{mess})$$

berechnet wird.

4. Verfahren nach Anspruch 3, **dadurch gekennzeichnet, dass** die Spannung $U_{mess}$ in Form von diskreten Spannungsmesswerten $U_{mess}^i$ in einem vorgegebenen zeitlichen Abstand $\Delta t$ oder zu vorgegebenen Zeitpunkten erfasst wird und dass der Näherungswert $SOC_{mod}$ für den Ladezustand durch Diskretisierung der Gleichung gemäß Anspruch 3 unter Verwendung eines mathematischen Diskretisierungsverfahrens berechnet wird, insbesondere unter Verwendung der expliziten Vorwärts-Euler-Methode aus der Gleichung

$$SOC_{mod}^{i+1} = SOC_{mod}^i - \frac{\Delta t}{R_i \cdot C_N} \cdot \left(U^0(SOC_{mod}^i) - U_{mess}^i\right)$$

wobei mit i der Index für einen Zeitschritt bezeichnet wird.

5. Verfahren nach Anspruch 3, **dadurch gekennzeichnet, dass** zusätzlich ein linearer Zusammenhang zwischen der Leerlaufspannung $U^0$ und dem Ladezustand $SOC_{mod}$ vorausgesetzt wird und dass der Ladezustand aus den Beziehungen

$$\frac{dSOC_{mod}}{dt} = -\frac{1}{R_i \cdot C_N}\left((U_L - U_E) \cdot SOC_{mod} + U_E - U_{mess}\right)$$

und

$$I_{mod} = \frac{1}{R_i}\left((U_L - U_E) \cdot SOC_{mod} + U_E - U_{mess}\right)$$

berechnet wird, wobei mit $U_L$ eine Ladeschlussspannung und mit $U_E$ eine Entladeschlussspannung bezeichnet ist.

6. Verfahren nach Anspruch 5, **dadurch gekennzeichnet, dass** die Spannung $U_{\text{mess}}$ in Form von diskreten Spannungsmesswerten $U_{mess}^{i}$ in einem vorgegebenen zeitlichen Abstand $\Delta t$ erfasst wird und dass der Näherungswert $SOC_{\text{mod}}$ für den Ladezustand durch Diskretisierung der Gleichungen gemäß Anspruch 5 unter Verwendung eines mathematischen Diskretisierungsverfahrens berechnet wird, insbesondere unter Verwendung der impliziten Rückwärts-Euler-Methode aus den Gleichungen

$$I_{\text{Modell}}^{i+1} = \frac{1}{\frac{(U_L - U_E)}{C_{\text{N}}}\Delta t + R_i}\left((U_L - U_E) \cdot SOC_{\text{Modell}}^{i} + U_E - U_{\text{Messung}}^{i+1}\right)$$

und

$$SOC_{\text{Modell}}^{i+1} = SOC_{\text{Modell}}^{i} - \frac{I_{\text{Modell}}^{i+1}}{C_{\text{N}}}\Delta t$$

wobei mit i der Index für einen Zeitschritt bezeichnet wird.

7. Verfahren nach Anspruch 1, **dadurch gekennzeichnet,**

(a) **dass** als mathematisches Batteriemodell ein Äquivalenzschaltkreismodell verwendet wird, welches durch die Gleichungen gemäß den Merkmalen (a) (iv) (1)und (a) (iv) (2)des Anspruchs 1 beschrieben ist, wobei die Gleichung gemäß Merkmal (a) (iv) (2)des Anspruchs 1 ersetzt wird durch das Gleichungssystem:

(i)

$$U_{\text{mess}} = U^0(SOC_{\text{mess}}, T_{\text{mod}} + \Delta U_{\text{hys}}(I_{\text{mod}}) - U_{\text{RC,an}} - U_{\text{RC,ca}} - I_{\text{mod}} R_{\text{s}}(T_{\text{mod}})$$

(ii)

$$\frac{dU_{\text{RC,an}}}{dt} = \frac{1}{C_{\text{DL,an}}(T_{\text{mod}})}\left(I_{\text{mod}} - \frac{U_{\text{RC,an}}}{R_{\text{CT,an}}(T_{\text{mod}})}\right)$$

(iii)

$$\frac{dU_{\text{RC,ca}}}{dt} = \frac{1}{C_{\text{DL,ca}}(T_{\text{mod}})}\left(I_{\text{mod}} - \frac{U_{\text{RC,ca}}}{R_{\text{CT,ca}}(T_{\text{mod}},I_{\text{mod}})}\right)$$

(iv)

$$\frac{dT_{\text{mod}}}{dt} = \frac{1}{C_{\text{th}}}\left(I_{\text{mod}}^2 R_{\text{s}}(T_{\text{mod}}) + \frac{U_{\text{RC,an}}^2}{R_{\text{CT,an}}(T_{\text{mod}})} + \frac{U_{\text{RC,ca}}^2}{R_{\text{CT,ca}}(T_{\text{mod}},I_{\text{mod}})} - \right.$$
$$\left. \frac{T_{\text{mod}} - T_{\text{mess}}^{\text{Umg}}}{R_{\text{th}}} + I_{\text{mod}} \cdot (T_{\text{mod}} - T^0) \cdot \frac{dU^0(SOC_{\text{mod}})}{dT}\right)$$

wobei mit $U_{\text{RC}}$ ein Spannungsabfall über ein RC-Element bezeichnet ist, mit $R_{\text{CT}}$ ein Ladungstransferwiderstand, mit $C_{\text{DL}}$ eine Doppelschichtkapazität, mit $C_{\text{th}}$ eine Wärmekapazität, mit $R_{\text{th}}$ ein Wärmeübergangswiderstand an der Batterieoberfläche, mit $dU^0(SOC_{\text{mod}})/dT$ eine Temperaturabhängigkeit der Leerlaufspannung, mit $T^0$ eine zugehörige Referenztemperatur und mit $T_{\text{mess}}^{\text{Umg}}$ eine gemessene Umgebungstemperatur der Batterie (106), wobei die Indizes "an" und "ca" auf eine Anode und eine Kathode der Batterie verweisen und wobei eine Asymmetrie der Leerlaufspannung $U^0$ durch $\Delta U_{\text{hys}}$ beschrieben wird und eine Asymmetrie des Kathodenwiderstands durch eine stromabhängigkeit von $R_{\text{CT,ca}}$, und
(b) **dass** aus diesem Gleichungssystem der Wert für den Ladezustand $SOC_{\text{mod}}$ berechnet wird, vorzugsweise mittels eines oder mehrerer numerischer mathematischer Verfahren.

8. Verfahren zur Bestimmung des Gesundheitszustandes einer aufladbaren Batterie eines vorgegebenen Batterietyps oder eines damit in einem physikalischen Zusammenhang stehenden Parameters, insbesondere einer aktuellen Kapazität C der Batterie, welche folgende Schritte umfasst:

(a) Erstellen eines spannungsgeführten dynamischen mathematischen Batteriemodells für die Batterie (106) oder einen vorgegebenen Batterietyp für die Batterie,

(i) welches einen Ladezustand der Batterie $SOC_{mod}$ oder den damit in einem physikalischen Zusammenhang stehenden Parameter mit einem Batteriestrom $I_{mod}$ verknüpft, und

(ii) welches eine zwischen den beiden Polen der Batterie (106) gemessene Spannung $U_{mess}$ in Abhängigkeit von einer Summe aus einer Leerlaufspannung $U^0$ der Batterie und einer Überspannung $\eta$ definiert,

(iii) wobei die Leerlaufspannung $U^0$ zumindest von der restlichen Ladungsmenge Q oder dem damit in einem physikalischen Zusammenhang stehenden Parameter und die Überspannung $\eta$ zumindest von dem Batteriestrom $I_{mod}$ abhängt;

(iv) wobei das spannungsgeführte dynamische mathematische Batteriemodell aus einem impliziten Gleichungssystem besteht oder hieraus entwickelt ist, welches folgende Gleichungen umfasst:

(1)

$$\frac{\mathrm{d}SOC_{mod}}{\mathrm{d}t} = -\frac{I_{mod}}{C_N}$$

(2)

$$U_{mess} = U^0(SOC_{mod}, T_{mess}, t) + \eta(I_{mod}, SOC_{mod}, T_{mess}, t)$$

wobei mit $C_N$ eine vorgegebenen Nennkapazität der Batterie (106), mit $T_{mess}$ eine gemessene Temperatur der Batterie (106) und mit t die Zeit bezeichnet ist, wobei die Leerlaufspannung $U^0$ zwingend eine Abhängigkeit vom Ladezustand $SOC_{mod}$ zeigt, während die Abhängigkeit von der gemessenen Temperatur $T_{mess}$ und der Zeit t optional ist, und wobei die Überspannung $\eta$ zwingend eine Abhängigkeit vom Batteriestrom $I_{mod}$ zeigt, während Parametrieren des spannungsgeführten dynamischen mathematischen Batteriemodells für die Batterie (106) oder den vorgegebenen Batterietyp;

(b) Bestimmung einer von der Batterie während eines ersten Beobachtungszeitraums aufgenommenen Ladungsmenge $Q_{in,mess}$ und/oder einer von der Batterie (106) während eines zweiten Beobachtungszeitraums abgegebenen Ladungsmenge $Q_{out,mess}$ durch Messung und Integration eines von der Batterie (106) abgegebenen oder aufgenommenen Batteriestroms $I_{mess}$, wobei der zweite Beobachtungszeitraum vorzugsweise identisch oder zumindest überlappend mit dem ersten Beobachtungszeitraum gewählt ist;

(c) Berechnung einer von der Batterie während des ersten Beobachtungszeitraums aufgenommenen Ladungsmenge $Q_{in,mod}$ und einer von der Batterie (106) während des zweiten Beobachtungszeitraums abgegebene Ladungsmenge $Q_{out,mod}$ unter Verwendung des für die Batterie (106) oder den vorgegebenen Batterietyp parametrierten spannungsgeführten dynamischen mathematischen Batteriemodells; und

(d) Bestimmung eines Näherungswertes $SOH_{mod}$ für den tatsächlichen Gesundheitszustand SOH durch Berechnen eines Lade-Gesundheitszustandes $SOH_{in}$ als Quotient aus der Ladungsmenge $Q_{in,mess}$ und der Ladungsmenge $Q_{in,mod}$ und/oder eines Entlade-Gesundheitszustandes $SOH_{out}$ als Quotient aus der Ladungsmenge $Q_{out,mess}$ und der Ladungsmenge $Q_{out,mod}$ und Verwenden des Lade-Gesundheitszustandes $SOH_{in}$ oder des Entlade-Gesundheitszustandes $SOH_{out}$ oder eines hieraus berechneten Mittelwertes als Näherungswert $SOH_{mod}$ für den tatsächlichen Gesundheitszustand SOH.

9. Verfahren nach Anspruch 8, **dadurch gekennzeichnet, dass** der erste und der zweite Zeitraum so gewählt werden, dass die während des betreffenden Zeitraums geladenen Ladungsmengen $Q_{in,mess}$ und/oder entladenen Ladungsmengen $Q_{out,mess}$ und/oder die Betragssumme hiervon größer sind als ein jeweils vordefinierter Wert, wobei der vordefinierte Wert vorzugsweise größer als die Nennkapazität $C_N$ der Batterie (106) ist.

10. Verfahren nach einem der Ansprüche 8 oder 9, **dadurch gekennzeichnet, dass** die Endzeitpunkte des ersten und zweiten Zeitraums so gewählt werden, dass an den Endzeitpunkten derselbe Ladezustand $SOC_{ref}$ besteht wie an den Anfangszeitpunkten und/oder dass an den Endzeitpunkten dieselbe Stromrichtung des gemessenen Batteriestroms $I_{mess}$ herrscht wie an den Anfangszeitpunkten.

11. Verfahren nach einem der Ansprüche 8 bis 10, **dadurch gekennzeichnet, dass** die Ladungsmengen $Q_{in,mod}$ und $Q_{out,mod}$ durch Integration des aus dem dynamischen mathematischen Batteriemodell berechneten Batteriestroms $I_{mod}$ berechnet werden.

12. Verfahren nach einem der Ansprüche 8 bis 11, **dadurch gekennzeichnet, dass** die Leerlaufspannung $U^0$ als ausschließlich vom Ladezustand $SOC_{mod}$ abhängig vorausgesetzt wird, dass ein konstanter Innenwiderstand $R_i$ der Batterie (106) vorausgesetzt wird, dass eine Temperaturunabhängigkeit des Batteriemodells vorausgesetzt wird und dass der Batteriestrom $I_{mod}$ berechnet wird aus der durch analytische Inversion gewonnenen Gleichung:

$$I_{\mathrm{mod}} = \frac{1}{R_\mathrm{i}}\left(U^0(\mathrm{SOC}_{\mathrm{mod}}) - U_{\mathrm{mess}}\right)$$

wobei die Abhängigkeit der Leerlaufspannung $U^0$ vom Ladezustand $SOC_{mod}$ insbesondere durch Messung, insbesondere als gemessene diskrete Werte oder als analytische Funktion, ermittelt wird.

13. Verfahren nach Anspruch 12, **dadurch gekennzeichnet, dass** die Spannung $U_{mess}$ in Form von diskreten Spannungsmesswerten $U_{mess}^i$ in einem vorgegebenen zeitlichen Abstand $\Delta t$ erfasst wird und dass der Batteriestrom $I_{mess}$ durch Diskretisierung der Gleichung gemäß Anspruch 14 unter Verwendung eines mathematischen Diskretisierungsverfahrens berechnet wird, insbesondere unter Verwendung der expliziten Vorwärts-Euler-Methode aus der Gleichung

$$I_{\mathrm{mod}}^{i} = \frac{1}{R_\mathrm{i}}\left(U^0\left(\mathrm{SOC}_{\mathrm{mod}}^{i}\right) - U_{\mathrm{mess}}^{i}\right)$$

wobei mit i der Index für einen Zeitschritt bezeichnet wird.

14. Verfahren nach Anspruch 12, **dadurch gekennzeichnet, dass** zusätzlich ein linearer Zusammenhang zwischen der Leerlaufspannung $U^0$ und dem Ladezustand $SOC_{mod}$ vorausgesetzt wird und dass der Batteriestrom aus den Beziehungen

$$\frac{\mathrm{dSOC}_{\mathrm{mod}}}{\mathrm{d}t} = -\frac{1}{R_\mathrm{i} \cdot c_\mathrm{N}}\left((U_L - U_E) \cdot \mathrm{SOC}_{\mathrm{mod}} + U_E - U_{\mathrm{mess}}\right)$$

und

$$I_{\mathrm{mod}} = \frac{1}{R_\mathrm{i}}\left((U_L - U_E) \cdot \mathrm{SOC}_{\mathrm{mod}} + U_E - U_{\mathrm{mess}}\right)$$

berechnet wird, wobei mit $U_L$ eine Ladeschlussspannung und mit $U_E$ eine Entladeschlussspannung bezeichnet ist.

15. Verfahren nach Anspruch 14, **dadurch gekennzeichnet, dass** die Spannung $U_{mess}$ in Form von diskreten Spannungsmesswerten $U_{\mathrm{mess}}^i$ in einem vorgegebenen zeitlichen Abstand $\Delta t$ oder zu vorgegebenen Zeitpunkten erfasst wird und dass der Näherungswert $SOC_{mod}$ für den Ladezustand durch Diskretisierung der Gleichung gemäß Anspruch 16 unter Verwendung eines mathematischen Diskretisierungsverfahrens berechnet wird, insbesondere unter Verwendung der impliziten Rückwärts-Euler-Methode aus den Gleichungen

$$I_{\mathrm{mod}}^{i+1} = \frac{1}{\frac{(U_L - U_E)}{c_\mathrm{N}}\Delta t + R_i}\left((U_L - U_E) \cdot \mathrm{SOC}_{\mathrm{mod}}^{i} + U_E - U_{\mathrm{mess}}^{i+1}\right)$$

und

$$\text{SOC}^{i+1}_{\text{mod}} = \text{SOC}^{i}_{\text{mod}} - \frac{I^{i+1}_{\text{mod}}}{C_{\text{N}}} \Delta t$$

wobei mit i der Index für einen Zeitschritt bezeichnet wird.

**16.** Verfahren nach Anspruch 8 bis 11, **dadurch gekennzeichnet,**

(a) **dass** als mathematisches Batteriemodell ein Äquivalenzschaltkreismodell verwendet wird, welches durch die Gleichungen gemäß den Merkmalen (a) (iv) (1) und (a) (iv) (2) des Anspruchs 8 beschrieben ist, wobei die Gleichung gemäß Merkmal (a) (iv) (2) des Anspruchs 8 ersetzt wird durch das Gleichungssystem:

(i)

$$U_{\text{mess}} = U^0(\text{SOC}_{\text{mess}}, T_{\text{mod}}) + \Delta U_{\text{hys}}(I_{\text{mod}}) - U_{\text{RC,an}} - U_{\text{RC,ca}} - I_{\text{mod}} \cdot R_{\text{s}}(T_{\text{mod}})$$

(ii)

$$\frac{\mathrm{d}U_{\text{RC,an}}}{\mathrm{d}t} = \frac{1}{C_{\text{DL,an}}(T_{\text{mod}})} \left( I_{\text{mod}} - \frac{U_{\text{RC,an}}}{R_{\text{CT,an}}(T_{\text{mod}})} \right)$$

(iii)

$$\frac{\mathrm{d}U_{\text{RC,ca}}}{\mathrm{d}t} = \frac{1}{C_{\text{DL,ca}}(T_{\text{mod}})} \left( I_{\text{mod}} - \frac{U_{\text{RC,ca}}}{R_{\text{CT,ca}}(T_{\text{mod}}, I_{\text{mod}})} \right)$$

(iv)

$$\frac{\mathrm{d}T_{\text{mod}}}{\mathrm{d}t} = \frac{1}{C_{\text{th}}} \left( I^2_{\text{mod}} R_{\text{s}}(T_{\text{mod}}) + \frac{U^2_{\text{RC,an}}}{R_{\text{CT,an}}(T_{\text{mod}})} + \frac{U^2_{\text{RC,ca}}}{R_{\text{CT,ca}}(T_{\text{mod}}, I_{\text{mod}})} - \frac{T_{\text{mod}} - T^{\text{Umg}}_{\text{mess}}}{R_{\text{th}}} + I_{\text{mod}} \cdot (T_{\text{mod}} - T^0) \cdot \frac{\mathrm{d}U^0(\text{SOC}_{\text{mod}})}{\mathrm{d}T} \right)$$

wobei mit $U_{\text{RC}}$ ein Spannungsabfall über ein RC-Element bezeichnet ist, mit $R_{\text{CT}}$ ein Ladungstransferwiderstand, mit $C_{\text{DL}}$ eine Doppelschichtkapazität, mit $C_{\text{th}}$ eine Wärmekapazität, mit $R_{\text{th}}$ ein Wärmeübergangswiderstand an der Batterieoberfläche, mit d$U^0(\text{SOC}_{\text{mod}})$/d$T$ eine Temperaturabhängigkeit der Leerlaufspannung, mit $T^0$ eine zugehörige Referenztemperatur und mit $T^{\text{Um}}_{\text{mess}}$ eine gemessene Umgebungstemperatur der Batterie, wobei die Indizes "an" und "ca" auf eine Anode und eine Kathode der Batterie (106) verweisen und wobei eine Asymmetrie der Leerlaufspannung U$^0$ durch $\Delta U_{\text{hys}}$ beschrieben wird und eine Asymmetrie des Kathodenwiderstands durch eine Stromabhängigkeit von $R_{\text{CT,ca}}$,
(b) **dass** aus diesem Gleichungssystem der Batteriestrom I$_{\text{mod}}$ berechnet wird, vorzugsweise mittels eines oder mehrerer numerischer mathematischer Verfahren und
(c) **dass** die Ladungsmengen Q$_{\text{in,mod}}$ und Q$_{\text{out,mod}}$ durch Integration des aus dem dynamischen mathematischen Batteriemodell berechneten Batteriestroms I$_{\text{mod}}$ berechnet werden.

**17.** Vorrichtung zur Durchführung des Verfahrens nach einem der Ansprüche 1 bis 7, mit einer Einheit (110) zur Messung der Batteriespannung U$_{\text{mess}}$, vorzugsweise in äquidistanten zeitlichen Abständen $\Delta t$ oder zu vorgegebenen Zeitpunkten, und mit einer Einheit (118) zur Berechnung eines Näherungswertes SOC$_{\text{mod}}$ für den tatsächlichen Ladezustand SOC der Batterie (106), welche zur Durchführung des Verfahrens nach einem der Ansprüche 1 bis 7 ausgebildet ist.

**18.** Vorrichtung zur Durchführung des Verfahrens nach einem der Ansprüche 8 bis 16 mit einer Einheit (110) zur Messung der Batteriespannung $U_{mess}$, vorzugsweise in äquidistanten zeitlichen Abständen $\Delta t$, mit einer Einheit (112) zur Messung des Batteriestroms $I_{mess}$ und mit einer Einheit (118) zur Berechnung eines Näherungswertes $SOH_{mod}$ für den tatsächlichen Gesundheitszustand SOH der Batterie, welche zur Durchführung des Verfahrens nach einem der Ansprüche 8 bis 16 ausgebildet ist.

**Claims**

**1.** Method for determining the state of charge of a rechargeable battery or a parameter physically related thereto, in particular a residual charge quantity Q contained in the battery, wherein the method comprises the following steps:

(a) creating a voltage-controlled dynamic mathematical battery model for the battery (106) or a specified battery type for the battery (106),

(i) which links a state of charge of the battery $SOC_{mod}$ or the parameter physically related thereto to a battery current $I_{mod}$, and
(ii) which defines a voltage $U_{mess}$ measured between the two poles of the battery (106) as a function of a sum of an open circuit voltage $U^0$ of the battery (106) and an overvoltage $\eta$,
(iii) wherein the open circuit voltage $U^0$ is dependent at least on the residual charge quantity Q or the parameter physically related thereto and the overvoltage $\eta$ is dependent at least on the battery current $I_{mod}$; and
(iv) wherein the voltage-controlled dynamic mathematical battery model consists of or is developed from an implicit system of equations comprising the following equations:

(1)

$$\frac{dSOC_{mod}}{dt} = \frac{I_{mod}}{C_N}$$

(2)

$$U_{mess} = U^0(SOC_{mod}, T_{mess}, t) + \eta(I_{mod}, SOC_{mod}, T_{mess}, t)$$

where $C_N$ denotes a specified nominal capacity of the battery (106), $T_{mess}$ denotes a measured temperature of the battery (106) and t denotes the time, wherein the open circuit voltage $U^0$ necessarily exhibits a dependence on the state of charge $SOC_{mod}$, while the dependence on the measured temperature $T_{mess}$ and the time t is optional, and wherein the overvoltage $\eta$ necessarily exhibits a dependence on the battery current $I_{mod}$, while the dependence on the state of charge $SOC_{mod}$ and the time t is optional;
(b) parameterizing the voltage-controlled dynamic mathematical battery model for the battery (106) or the specified battery type; and
(c) determining an approximate value $SOC_{mod}$ for the actual state of charge SOC of the battery (106) or the parameter physically related thereto by measuring the battery voltage $U_{mess}$ and calculating the approximate value $SOC_{mod}$ using the parameterized voltage-controlled dynamic mathematical battery model.

**2.** Method according to claim 1, **characterized in that** the open circuit voltage $U^0$ is assumed to be exclusively dependent on the state of charge $SOC_{mod}$, **in that** a constant internal resistance $R_i$ of the battery (106) is assumed, **and in that** temperature independence of the battery model is assumed, such that the battery model is defined by the following equations:

(a)

$$\frac{dSOC_{mod}}{dt} = -\frac{I_{mod}}{C_N}$$

(b)

$$U_{\text{mess}} = U^0(\text{SOC}_{\text{mod}}) - R_{\text{i}} \cdot I_{\text{mod}},$$

the dependence of the open circuit voltage $U^0$ on the state of charge $\text{SOC}_{\text{mod}}$ being ascertained in particular by measurement, in particular as measured discrete values or as an analytical function.

3. Method according to claim 2, **characterized in that** the two equations are solved by analytical inversion, the state of charge $\text{SOC}_{\text{mod}}$ being calculated from the equations

$$\frac{\text{dSOC}_{\text{mod}}}{\text{d}t} = -\frac{1}{R_{\text{i}} \cdot C_{\text{N}}} \cdot (U^0(\text{SOC}_{\text{mod}}) - U_{\text{mess}})$$

$$I_{\text{mod}} = \frac{1}{R_{\text{i}}}(U^0(\text{SOC}_{\text{mod}}) - U_{\text{mess}})$$

4. Method according to claim 3, **characterized in that** the voltage $U_{\text{mess}}$ is captured in the form of discrete measured voltage values $U^i_{\text{mess}}$ at a specified time interval $\Delta$t or at specified points in time, **and in that** the approximate value $\text{SOC}_{\text{mod}}$ for the state of charge is calculated by discretization of the equation according to claim 3 using a mathematical discretization method, in particular using the explicit forward Euler method, from the equation

$$\text{SOC}^{i+1}_{\text{mod}} = \text{SOC}^i_{\text{mod}} - \frac{\Delta t}{R_i \cdot C_{\text{N}}} \cdot \left(U^0\left(\text{SOC}^i_{\text{mod}}\right) - U^i_{\text{mess}}\right)$$

where i denotes the index for a time step.

5. Method according to claim 3, **characterized in that** in addition a linear correlation is assumed between the open circuit voltage $U^0$ and the state of charge $\text{SOC}_{\text{mod}}$, **and in that** the state of charge is calculated from the relationships

$$\frac{\text{dSOC}_{\text{mod}}}{\text{d}t} = -\frac{1}{R_i \cdot C_{\text{N}}}\left((U_L - U_E) \cdot \text{SOC}_{\text{mod}} + U_E - U_{\text{mess}}\right)$$

and

$$I_{\text{mod}} = \frac{1}{R_i}\left((U_L - U_E) \cdot \text{SOC}_{\text{mod}} + U_E - U_{\text{mess}}\right)$$

where $U_L$ denotes an end-of-charge voltage and $U_E$ denotes an end-of-discharge voltage.

6. Method according to claim 5, **characterized in that** the voltage $U_{\text{mess}}$ is captured in the form of discrete measured voltage values $U^i_{\text{mess}}$ at a specified time interval $\Delta$t, **and in that** the approximate value $\text{SOC}_{\text{mod}}$ for the state of charge is calculated by discretization of the equations according to claim 5 using a mathematical discretization method, in particular using the implicit backward Euler method, from the equations

$$I^{i+1}_{\text{Modell}} = \frac{1}{\frac{(U_L - U_E)}{C_{\text{N}}}\Delta t + R_i}\left((U_L - U_E) \cdot \text{SOC}^i_{\text{Modell}} + U_E - U^{i+1}_{\text{Messung}}\right)$$

and

$$\text{SOC}_{\text{Modell}}^{i+1} = \text{SOC}_{\text{Modell}}^{i} - \frac{I_{\text{Modell}}^{i+1}}{C_{\text{N}}} \Delta t$$

where i denotes the index for a time step.

7. Method according to claim 1, **characterized**

(a) **in that,** as the mathematical battery model, an equivalent circuit model is used, which is described by the equations according to features (a) (iv) (1) and (a) (iv) (2) of claim 1, the equation according to feature (a) (iv) (2) of claim 1 being replaced by the system of equations:

(i) $\quad U_{\text{mess}} = U^0(\text{SOC}_{\text{mess}}, T_{\text{mod}}) + \Delta U_{\text{hys}}(I_{\text{mod}}) - U_{\text{RC,an}} - U_{\text{RC,ca}} - I_{\text{mod}} \cdot$

$R_{\text{s}}(T_{\text{mod}})$

(ii) $\quad \dfrac{\mathrm{d}U_{\text{RC,an}}}{\mathrm{d}t} = \dfrac{1}{C_{\text{DL,an}}(T_{\text{mod}})}\left(I_{\text{mod}} - \dfrac{U_{\text{RC,an}}}{R_{\text{CT,an}}(T_{\text{mod}})}\right)$

(iii) $\quad \dfrac{\mathrm{d}U_{\text{RC,ca}}}{\mathrm{d}t} = \dfrac{1}{C_{\text{DL,ca}}(T_{\text{mod}})}\left(I_{\text{mod}} - \dfrac{U_{\text{RC,ca}}}{R_{\text{CT,ca}}(T_{\text{mod}},I_{\text{mod}})}\right)$

(iv) $\quad \dfrac{\mathrm{d}T_{\text{mod}}}{\mathrm{d}t} = \dfrac{1}{C_{\text{th}}}\left(I_{\text{mod}}^2 R_{\text{s}}(T_{\text{mod}}) + \dfrac{U_{\text{RC,an}}^2}{R_{\text{CT,an}}(T_{\text{mod}})} + \dfrac{U_{\text{RC,ca}}^2}{R_{\text{CT,ca}}(T_{\text{mod}},I_{\text{mod}})} - \dfrac{T_{\text{mod}}-T_{\text{mess}}^{\text{Umg}}}{R_{\text{th}}} + \right.$

$\left. I_{\text{mod}} \cdot (T_{\text{mod}} - T^0) \cdot \dfrac{\mathrm{d}U^0(\text{SOC}_{\text{mod}})}{\mathrm{d}T}\right)$

where $U_{\text{RC}}$ denotes a drop in voltage across an RC element, $R_{\text{CT}}$ denotes a charge transfer resistance, $C_{\text{DL}}$ denotes a double-layer capacitance, $C_{\text{th}}$ denotes a heat capacity, $R_{\text{th}}$ denotes a heat transfer resistance on the battery surface, $\mathrm{d}U^0(\text{SOC}_{\text{mod}})/\mathrm{d}T$ denotes a temperature dependence of the open circuit voltage, $T^0$ denotes an associated reference temperature, and $T_{\text{mess}}^{\text{Umg}}$ denotes a measured ambient temperature of the battery (106), where the indices "an" and "ca" refer to an anode and a cathode of the battery and where an asymmetry of the open circuit voltage $U^0$ is described by $\Delta U_{\text{hys}}$ and an asymmetry of the cathode resistance is described by a current dependence on $R_{\text{CT,ca}}$, and
(b) **in that** the value for the state of charge $\text{SOC}_{\text{mod}}$ is calculated from this system of equations, preferably by means of one or more numerical mathematical methods.

8. Method for determining the state of health of a rechargeable battery of a specified battery type or a parameter physically related thereto, in particular a present capacity C of the battery, comprising the following steps:

(a) creating a voltage-controlled dynamic mathematical battery model for the battery (106) or a specified battery type for the battery,

(i) which links a state of charge of the battery $\text{SOC}_{\text{mod}}$ or the parameter physically related thereto to a battery current $I_{\text{mod}}$, and
(ii) which defines a voltage $U_{\text{mess}}$ measured between the two poles of the battery (106) as a function of a sum of an open circuit voltage $U^0$ of the battery and an overvoltage $\eta$,
(iii) wherein the open circuit voltage $U^0$ is dependent at least on the residual charge quantity Q or the parameter physically related thereto and the overvoltage $\eta$ is dependent at least on the battery current $I_{\text{mod}}$,
(iv) wherein the voltage-controlled dynamic mathematical battery model consists of or is developed from an implicit system of equations comprising the following equations:

(1)

$$\frac{\mathrm{dSOC_{mod}}}{\mathrm{d}t} = -\frac{I_{\mathrm{mod}}}{C_{\mathrm{N}}}$$

(2)

$$U_{\mathrm{mess}} = U^0(\mathrm{SOC_{mod}}, T_{\mathrm{mess}}, t) + \eta(I_{\mathrm{mod}}, \mathrm{SOC_{mod}}, T_{\mathrm{mess}}, t)$$

where $C_{\mathrm{N}}$ denotes a specified nominal capacity of the battery (106), $T_{\mathrm{mess}}$ denotes a measured temperature of the battery (106) and t denotes the time, wherein the open circuit voltage $U^0$ necessarily exhibits a dependence on the state of charge $\mathrm{SOC_{mod}}$, while the dependence on the measured temperature $T_{\mathrm{mess}}$ and the time t is optional, and wherein the overvoltage $\eta$ necessarily exhibits a dependence on the battery current $I_{\mathrm{mod}}$, during parameterization of the voltage-controlled dynamic mathematical battery model for the battery (106) or the specified battery type;

(b) determining a charge quantity $Q_{\mathrm{in,mess}}$ received by the battery during a first observation period and/or a charge quantity $Q_{\mathrm{out,mess}}$ provided by the battery (106) during a second observation period, by measuring and integrating a battery current $I_{\mathrm{mess}}$ supplied or received by the battery (106), wherein the second observation period is preferably selected to be identical to or at least overlapping with the first observation period;
(c) calculating a charge quantity $Q_{\mathrm{in,mod}}$ received by the battery during the first observation period and a charge quantity $Q_{\mathrm{out,mod}}$ supplied by the battery (106) during the second observation period using the voltage-controlled dynamic mathematical battery model parameterized for the battery (106) or the specified battery type; and
(d) determining an approximate value $\mathrm{SOH_{mod}}$ for the actual state of health SOH, by calculating a charge state of health $\mathrm{SOH_{in}}$ as a quotient of the charge quantity $Q_{\mathrm{in,mess}}$ and the charge quantity $Q_{\mathrm{in,mod}}$ and/or a discharge state of health $\mathrm{SOH_{out}}$ as a quotient of the charge quantity $Q_{\mathrm{out,mess}}$ and the charge quantity $Q_{\mathrm{out,mod}}$ and using the charge state of health $\mathrm{SOH_{in}}$ or the discharge state of health $\mathrm{SOH_{out}}$ or an average value calculated therefrom as an approximate value $\mathrm{SOH_{mod}}$ for the actual state of health SOH.

9. Method according to claim 8, **characterized in that** the first and the second period are selected such that the charge quantities $Q_{\mathrm{in,mess}}$ charged and/or the charge quantities $Q_{\mathrm{out,mess}}$ discharged during the relevant period and/or the sum of these quantities are greater than a value predefined in each case, the predefined value being preferably greater than the nominal capacity $C_{\mathrm{N}}$ of the battery (106).

10. Method according to any of claims 8 or 9, **characterized in that** the end points in time of the first and the second period are selected such that the same state of charge $\mathrm{SOC_{ref}}$ exists at the end points in time as at the start points in time and/or that the same current direction of the measured battery current $I_{\mathrm{mess}}$ prevails at the end points in time as at the start points in time.

11. Method according to any of claims 8 to 10, **characterized in that** the charge quantities $Q_{\mathrm{in,mod}}$ and $Q_{\mathrm{out,mod}}$ are calculated by integrating the battery current $I_{\mathrm{mod}}$ calculated from the dynamic mathematical battery model.

12. Method according to any of claims 8 to 11, **characterized in that** the open circuit voltage $U^0$ is assumed to be exclusively dependent on the state of charge $\mathrm{SOC_{mod}}$, **in that** a constant internal resistance $R_{\mathrm{i}}$ of the battery (106) is assumed, **in that** temperature independence of the battery model is assumed, **and in that** the battery current $I_{\mathrm{mod}}$ is calculated from the equation obtained by analytical inversion:

$$I_{\mathrm{mod}} = \frac{1}{R_{\mathrm{i}}}(U^0(\mathrm{SOC_{mod}}) - U_{\mathrm{mess}})$$

the dependence of the open circuit voltage $U^0$ on the state of charge $\mathrm{SOC_{mod}}$ being ascertained in particular by measurement, in particular as measured discrete values or as an analytical function.

13. Method according to claim 12, **characterized in that** the voltage $U_{\mathrm{mess}}$ is captured in the form of discrete measured voltage values $U^i_{mess}$ at a specified time interval $\Delta t$, **and in that** the battery current $I_{\mathrm{mess}}$ is calculated by discretization of the equation according to claim 14 using a mathematical discretization method, in particular using the explicit forward Euler method, from the equation

$$I_{\text{mod}}^i = \frac{1}{R_i}\left(U^0\left(\text{SOC}_{\text{mod}}^i\right) - U_{\text{mess}}^i\right)$$

where i denotes the index for a time step.

**14.** Method according to claim 12, **characterized in that** in addition a linear correlation is assumed between the open circuit voltage $U^0$ and the state of charge $SOC_{\text{mod}}$, **and in that** the battery current is calculated from the relationships

$$\frac{\text{dSOC}_{\text{mod}}}{\text{d}t} = -\frac{1}{R_i \cdot C_N}\left((U_L - U_E)\cdot \text{SOC}_{\text{mod}} + U_E - U_{\text{mess}}\right)$$

and

$$I_{\text{mod}} = \frac{1}{R_i}\left((U_L - U_E)\cdot \text{SOC}_{\text{mod}} + U_E - U_{\text{mess}}\right)$$

where $U_L$ denotes an end-of-charge voltage and $U_E$ denotes an end-of-discharge voltage.

**15.** Method according to claim 14, **characterized in that** the voltage $U_{\text{mess}}$ is captured in the form of discrete measured voltage values $U_{mess}^i$ at a specified time interval $\Delta t$ or at specified points in time, **and in that** the approximate value $SOC_{\text{mod}}$ for the state of charge is calculated by discretization of the equation according to claim 16 using a mathematical discretization method, in particular using the implicit backward Euler method, from the equations

$$I_{\text{mod}}^{i+1} = \frac{1}{\frac{(U_L - U_E)}{C_N}\Delta t + R_i}\left((U_L - U_E)\cdot \text{SOC}_{\text{mod}}^i + U_E - U_{\text{mess}}^{i+1}\right)$$

and

$$\text{SOC}_{\text{mod}}^{i+1} = \text{SOC}_{\text{mod}}^i - \frac{I_{\text{mod}}^{i+1}}{C_N}\Delta t$$

where i denotes the index for a time step.

**16.** Method according to claims 8 to 11, **characterized**

(a) **in that,** as the mathematical battery model, an equivalent circuit model is used, which is described by the equations according to features (a) (iv) (1) and (a) (iv) (2) of claim 8, the equation according to feature (a) (iv) (2) of claim 8 being replaced by the system of equations:

$U_{\text{mess}} = U^0(SOC_{\text{mess}}, T_{\text{mod}} + \Delta U_{\text{hys}}(I_{\text{mod}}) - U_{\text{RC,an}} - U_{\text{RC,ca}} - I_{\text{mod}} R_s(T_{\text{mod}})$

(ii) $\quad \dfrac{\text{d}U_{\text{RC,an}}}{\text{d}t} = \dfrac{1}{C_{\text{DL,an}}(T_{\text{mod}})}\left(I_{\text{mod}} - \dfrac{U_{\text{RC,an}}}{R_{\text{CT,an}}(T_{\text{mod}})}\right)$

(iii) $\quad \dfrac{\text{d}U_{\text{RC,ca}}}{\text{d}t} = \dfrac{1}{C_{\text{DL,ca}}(T_{\text{mod}})}\left(I_{\text{mod}} - \dfrac{U_{\text{RC,ca}}}{R_{\text{CT,ca}}(T_{\text{mod}}, I_{\text{mod}})}\right)$

(iv) $\quad \dfrac{\mathrm{d}T_{\mathrm{mod}}}{\mathrm{d}t} = \dfrac{1}{C_{\mathrm{th}}}\left(I^2_{\mathrm{mod}}R_{\mathrm{s}}(T_{\mathrm{mod}}) + \dfrac{U^2_{\mathrm{RC,an}}}{R_{\mathrm{CT,an}}(T_{\mathrm{mod}})} + \dfrac{U^2_{\mathrm{RC,ca}}}{R_{\mathrm{CT,ca}}(T_{\mathrm{mod}},I_{\mathrm{mod}})} - \dfrac{T_{\mathrm{mod}}-T^{\mathrm{Umg}}_{\mathrm{mess}}}{R_{\mathrm{th}}} + \right.$

$$\left. I_{\mathrm{mod}}\cdot(T_{\mathrm{mod}} - T^0)\cdot\dfrac{\mathrm{d}U^0(\mathrm{SOC}_{\mathrm{mod}})}{\mathrm{d}T}\right)$$

where $U_{\mathrm{RC}}$ denotes a drop in voltage across an RC element, $R_{\mathrm{CT}}$ denotes a charge transfer resistance, $C_{\mathrm{DL}}$ denotes a double-layer capacitance, $C_{\mathrm{th}}$ denotes a heat capacity, $R_{\mathrm{th}}$ denotes a heat transfer resistance on the battery surface, $\mathrm{d}U^0(\mathrm{SOC}_{\mathrm{mod}})/\mathrm{d}T$ denotes a temperature dependence of the open circuit voltage, $T^0$ denotes an associated reference temperature, and $T^{\mathrm{Um}}_{\mathrm{mess}}$ denotes a measured ambient temperature of the battery, where the indices "an" and "ca" refer to an anode and a cathode of the battery (106) and where an asymmetry of the open circuit voltage $U^0$ is described by $\varDelta U_{\mathrm{hys}}$ and an asymmetry of the cathode resistance is defined by a current dependence on $R_{\mathrm{CT,ca}}$,

(b) **in that** the battery current $I_{\mathrm{mod}}$ is calculated from this system of equations, preferably by means of one or more numerical mathematical methods and

(c) **in that** the charge quantities $Q_{\mathrm{in,mod}}$ and $Q_{\mathrm{out,mod}}$ are calculated by integrating the battery current $I_{\mathrm{mod}}$ calculated from the dynamic mathematical battery model.

**17.** Device for carrying out the method according to any of claims 1 to 7, comprising a unit (110) for measuring the battery voltage $U_{\mathrm{mess}}$, preferably at equidistant time intervals $\Delta t$ or at specified points in time, and comprising a unit (118) for calculating an approximate value $\mathrm{SOC}_{\mathrm{mod}}$ for the actual state of charge SOC of the battery (106), which device is designed to carry out the method according to any of claims 1 to 7.

**18.** Device for carrying out the method according to any of claims 8 to 16, comprising a unit (110) for measuring the battery voltage $U_{\mathrm{mess}}$, preferably at equidistant time intervals $\Delta t$, comprising a unit (112) for measuring the battery current $I_{\mathrm{mess}}$ and comprising a unit (118) for calculating an approximate value $\mathrm{SOH}_{\mathrm{mod}}$ for the actual state of health SOH of the battery, which device is designed to carry out the method according to any of claims 8 to 16.

**Revendications**

**1.** Procédé pour la détermination de l'état de charge d'une batterie rechargeable ou d'un paramètre qui y est physiquement lié, en particulier d'une quantité de charge restante Q contenue dans la batterie, dans lequel le procédé comprend les étapes suivantes :

(a) création d'un modèle de batterie mathématique dynamique guidé par la tension pour la batterie (106) ou un type de batterie prédéfini pour la batterie (106),

(i) lequel associe un état de charge de la batterie $\mathrm{SOC}_{\mathrm{mod}}$ ou le paramètre qui lui est physiquement lié à un courant de batterie $I_{\mathrm{mod}}$, et

(ii) lequel définit une tension $U_{\mathrm{mess}}$ mesurée entre les deux pôles de la batterie (106) en fonction d'une somme d'une tension à vide $U^0$ de la batterie (106) et d'une surtension $\eta$,

(iii) dans lequel la tension à vide $U^0$ dépend au moins de la quantité de charge restante Q ou du paramètre qui lui est physiquement lié, et la surtension $\eta$ dépend au moins du courant de batterie $I_{\mathrm{mod}}$ ; et

(iv) dans lequel le modèle de batterie mathématique dynamique guidé par la tension consiste en un système d'équations implicites comprenant les équations suivantes, ou est développé à partir de celui-ci :

(1)

$$\frac{\mathrm{d}\mathrm{SOC}_{\mathrm{mod}}}{\mathrm{d}t} = \frac{f_{\mathrm{mod}}}{c_{\mathrm{N}}}$$

(2)

$$U_{\mathrm{mess}} = U^0(\mathrm{SOC}_{\mathrm{mod}}, T_{\mathrm{mess}}, t) + \eta(I_{\mathrm{mod}}, \mathrm{SOC}_{\mathrm{mod}}, T_{\mathrm{mess}}, t)$$

où $C_N$ représente une capacité nominale prédéfinie de la batterie (106), $T_{mess}$ représente une température mesurée de la batterie (106) et t représente le temps, dans lequel la tension à vide $U^0$ montre obligatoirement une dépendance vis-à-vis de l'état de charge $SOC_{mod}$, tandis que la dépendance vis-à-vis de la température mesurée $T_{mess}$ et du temps t est facultative, et dans lequel la surtension $\eta$ montre obligatoirement une dépendance vis-à-vis du courant de batterie $I_{mod}$, tandis que la dépendance vis-à-vis de l'état de charge $SOC_{mod}$ et du temps t est facultative;

(b) paramétrage du modèle de batterie mathématique dynamique guidé par la tension pour la batterie (106) ou le type de batterie prédéfini ; et

(c) détermination d'une valeur approximative $SOC_{mod}$ pour l'état de charge réel SOC de la batterie (106) ou le paramètre qui y est physiquement lié en mesurant la tension de batterie $U_{mess}$ et en calculant la valeur approximative $SOC_{mod}$ en utilisant le modèle de batterie mathématique dynamique guidé par la tension paramétré.

2. Procédé selon la revendication 1, **caractérisé en ce que** la tension à vide $U^0$ est supposée comme dépendant exclusivement de l'état de charge $SOC_{mod}$, **en ce qu'**une résistance interne $R_i$ constante de la batterie (106) est supposée **et en ce qu'**une indépendance vis-à-vis de la température du modèle de batterie est supposée, de sorte que le modèle de batterie est défini par les équations suivantes :

(a)

$$\frac{dSOC_{mod}}{dt} = -\frac{I_{mod}}{C_N}$$

(b)

$$U_{mess} = U^0(SOC_{mod}) - R_i \cdot I_{mod},$$

dans lequel la dépendance de la tension à vide $U^0$ vis-à-vis de l'état de charge $SOC_{mod}$ est déterminée en particulier par mesure, en particulier en tant que valeurs discrètes mesurées ou en tant que fonction analytique.

3. Procédé selon la revendication 2, **caractérisé en ce que** les deux équations sont résolues par inversion analytique, dans lequel l'état de charge $SOC_{mod}$ est calculé à partir des équations

$$\frac{dSOC_{mod}}{dt} = -\frac{1}{R_i \cdot C_N} \cdot (U^0(soc_{mod}) - U_{mess})$$

$$I_{mod} = \frac{1}{R_i}(U^0(SOC_{mod}) - U_{mess})$$

4. Procédé selon la revendication 3, **caractérisé en ce que** la tension $U_{mess}$ est détectée en tant que valeurs mesurées de tension discrètes $U_{mess}^t$ dans un intervalle de temps $\Delta t$ prédéfini ou à des moments prédéfinis **et en ce que** la valeur approximative $SOC_{mod}$ pour l'état de charge est calculée par discrétisation de l'équation selon la revendication 3 en utilisant un procédé de discrétisation mathématique, en particulier en utilisant la méthode d'Euler explicite à partir de l'équation

$$SOC_{mod}^{i+1} = SOC_{mod}^i - \frac{\Delta t}{R_i \cdot C_N} \cdot \left(U^0\left(SOC_{mod}^i\right) - U_{mess}^i\right)$$

où i représente l'indice d'un intervalle de temps.

5. Procédé selon la revendication 3, **caractérisé en ce qu'**une relation linéaire entre la tension à vide $U^0$ et l'état de charge $SOC_{mod}$ est en outre supposée **et en ce que** l'état de charge est calculé à partir des relations

$$\frac{\text{dSOC}_{\text{mod}}}{\text{d}t} = -\frac{1}{R_i \cdot C_{\text{N}}}\left((U_L - U_E) \cdot \text{SOC}_{\text{mod}} + U_E - U_{\text{mess}}\right)$$

et

$$I_{\text{mod}} = \frac{1}{R_i}\left((U_L - U_E) \cdot \text{SOC}_{\text{mod}} + U_E - U_{\text{mess}}\right)$$

où $U_L$ représente une tension de fin de charge et $U_E$ représente une tension de fin de décharge.

6. Procédé selon la revendication 5, **caractérisé en ce que** la tension $U_{\text{mess}}$ est détectée en tant que valeurs mesurées de tension discrètes $U_{\text{mess}}^i$ dans un intervalle de temps Δt prédéfini **et en ce que** la valeur approximative $\text{SOC}_{\text{mod}}$ pour l'état de charge est calculée par discrétisation des équations selon la revendication 5 en utilisant un procédé de discrétisation mathématique, en particulier en utilisant la méthode d'Euler implicite à partir des équations

$$I_{\text{Modell}}^{i+1} = \frac{1}{\frac{(U_L - U_E)}{C_{\text{N}}}\Delta t + R_i}\left((U_L - U_E) \cdot \text{SOC}_{\text{Modell}}^i + U_E - U_{\text{Messung}}^{i+1}\right)$$

et

$$\text{SOC}_{\text{Modell}}^{i+1} = \text{SOC}_{\text{Modell}}^i - \frac{I_{\text{Modell}}^{i+1}}{C_{\text{N}}}\Delta t$$

où i représente l'indice d'un intervalle de temps.

7. Procédé selon la revendication 1, **caractérisé en ce**

(a) **que** l'on utilise comme modèle de batterie mathématique un modèle de circuit équivalent qui est décrit par les équations selon les caractéristiques (a) (iv) (1) et (a) (iv) (2) de la revendication 1, dans lequel l'équation selon la caractéristique (a) (iv) (2) de la revendication 1 est remplacée par le système d'équations :

(i) $\quad U_{\text{mess}} = U^0(\text{SOC}_{\text{mess}}, T_{\text{mod}}) + \Delta U_{\text{hys}}(I_{\text{mod}}) - U_{\text{RC,an}} - U_{\text{RC,ca}} - I_{\text{mod}} \cdot R_{\text{s}}(T_{\text{mod}})$

(ii) $\quad \dfrac{\text{d}U_{\text{RC,an}}}{\text{d}t} = \dfrac{1}{C_{\text{DL,an}}(T_{\text{mod}})}\left(I_{\text{mod}} - \dfrac{U_{\text{RC,an}}}{R_{\text{CT,an}}(T_{\text{mod}})}\right)$

(iii) $\quad \dfrac{\text{d}U_{\text{RC,ca}}}{\text{d}t} = \dfrac{1}{C_{\text{DL,ca}}(T_{\text{mod}})}\left(I_{\text{mod}} - \dfrac{U_{\text{RC,ca}}}{R_{\text{CT,ca}}(T_{\text{mod}},I_{\text{mod}})}\right)$

(iv) $\quad \dfrac{\text{d}T_{\text{mod}}}{\text{d}t} = \dfrac{1}{C_{\text{th}}}\left(I_{\text{mod}}^2 R_{\text{s}}(T_{\text{mod}}) + \dfrac{U_{\text{RC,an}}^2}{R_{\text{CT,an}}(T_{\text{mod}})} + \dfrac{U_{\text{RC,ca}}^2}{R_{\text{CT,ca}}(T_{\text{mod}},I_{\text{mod}})} - \dfrac{T_{\text{mod}} - T_{\text{mess}}^{\text{Umg}}}{R_{\text{th}}} + I_{\text{mod}} \cdot (T_{\text{mod}} - T^0) \cdot \dfrac{\text{d}U^0(\text{SOC}_{\text{mod}})}{\text{d}T}\right)$

où $U_{\text{RC}}$ représente une chute de tension aux bornes d'un élément RC, $R_{\text{CT}}$ représente une résistance de transfert de charge, $C_{\text{DL}}$ représente une capacité de double couche, $C_{\text{th}}$ représente une capacité thermique, $R_{\text{th}}$ représente une résistance de transfert de chaleur à la surface de la batterie, d$U^0$ ($\text{SOC}_{\text{mod}}$)/d$T$ représente une dépendance à la température de la tension à vide, $T^0$ représente une température de référence corres-

pondante et $T^{\mathrm{Umg}}_{\mathrm{mess}}$ représente une température ambiante mesurée de la batterie (106), dans lequel les indices « an » et « ca » renvoient à une anode et à une cathode de la batterie, et dans lequel une asymétrie de la tension à vide $U^0$ est décrite par $\Delta U_{\mathrm{hys}}$ et une asymétrie de la résistance de la cathode est décrite par une dépendance vis-à-vis du courant de $R_{\mathrm{CT,ca}}$, et

(b) **que** la valeur pour l'état de charge $SOC_{\mathrm{mod}}$ est calculée à partir dudit système d'équations, de préférence au moyen d'un ou de plusieurs procédés mathématiques numériques.

8. Procédé pour la détermination de l'état de santé d'une batterie rechargeable d'un type de batterie prédéfini ou d'un paramètre qui lui est physiquement lié, en particulier d'une capacité C actuelle de la batterie, lequel procédé comprend les étapes suivantes :

(a) création d'un modèle de batterie mathématique dynamique guidé par la tension pour la batterie (106) ou un type de batterie prédéfini pour la batterie,

(i) lequel associe un état de charge de la batterie $SOC_{\mathrm{mod}}$ ou le paramètre qui lui est physiquement lié à un courant de batterie $I_{\mathrm{mod}}$, et
(ii) lequel définit une tension $U_{\mathrm{mess}}$ mesurée entre les deux pôles de la batterie (106) en fonction d'une somme d'une tension à vide $U^0$ de la batterie et d'une surtension $\eta$,
(iii) dans lequel la tension à vide $U^0$ dépend au moins de la quantité de charge restante Q ou du paramètre qui lui est physiquement lié, et la surtension $\eta$ dépend au moins du courant de batterie $I_{\mathrm{mod}}$ ;
(iv) dans lequel le modèle de batterie mathématique dynamique guidé par la tension consiste en un système d'équations implicites comprenant les équations suivantes, ou est développé à partir de celui-ci :

(1)

$$\frac{\mathrm{d}SOC_{\mathrm{mod}}}{\mathrm{d}t} = -\frac{I_{\mathrm{mod}}}{C_{\mathrm{N}}}$$

(2)

$$U_{\mathrm{mess}} = U^0(SOC_{\mathrm{mod}}, T_{\mathrm{mess}}, t) + \eta(I_{\mathrm{mod}}, SOC_{\mathrm{mod}}, T_{\mathrm{mess}}, t)$$

où $C_{\mathrm{N}}$ représente une capacité nominale prédéfinie de la batterie (106), $T_{\mathrm{mess}}$ représente une température mesurée de la batterie (106) et t représente le temps, dans lequel la tension à vide $U^0$ montre obligatoirement une dépendance vis-à-vis de l'état de charge $SOC_{\mathrm{mod}}$, tandis que la dépendance vis-à-vis de la température mesurée $T_{\mathrm{mess}}$ et du temps t est facultative, et dans lequel la surtension $\eta$ montre obligatoirement une dépendance vis-à-vis du courant de batterie $I_{\mathrm{mod}}$, tout en paramétrant le modèle de batterie mathématique dynamique guidé par la tension pour la batterie (106) ou le type de batterie prédéfini ;
(b) détermination d'une quantité de charge $Q_{\mathrm{in,mess}}$ absorbée par la batterie pendant une première période d'observation et/ou d'une quantité de charge $Q_{\mathrm{out,mess}}$ fournie par la batterie (106) pendant une seconde période d'observation par mesure et intégration d'un courant de batterie $I_{\mathrm{mess}}$ fourni ou absorbé par la batterie (106), dans lequel la seconde période d'observation est de préférence choisie de manière à être identique à la première période d'observation ou à au moins la chevaucher ;
(c) calcul d'une quantité de charge $Q_{\mathrm{in,mod}}$ absorbée par la batterie pendant la première période d'observation et d'une quantité de charge $Q_{\mathrm{out,mod}}$ fournie par la batterie (106) pendant la seconde période d'observation en utilisant le modèle de batterie mathématique dynamique guidé par la tension paramétré pour la batterie (106) ou le type de batterie prédéfini ; et
(d) détermination d'une valeur approximative $SOH_{\mathrm{mod}}$ pour l'état de santé réel SOH en calculant un état de santé de charge $SOH_{\mathrm{in}}$ comme quotient de la quantité de charge $Q_{\mathrm{in,mess}}$ et de la quantité de charge $Q_{\mathrm{in,mod}}$ et/ou un état de santé de décharge $SOH_{\mathrm{out}}$ comme quotient de la quantité de charge $Q_{\mathrm{out,mess}}$ et de la quantité de charge $Q_{\mathrm{out,mod}}$ et en utilisant l'état de santé de charge $SOH_{\mathrm{in}}$ ou l'état de santé de décharge $SOH_{\mathrm{out}}$ ou une valeur moyenne calculée à partir de ceux-ci comme valeur approximative $SOH_{\mathrm{mod}}$ pour l'état de santé réel SOH.

9. Procédé selon la revendication 8, **caractérisé en ce que** les première et seconde périodes sont choisies de sorte que les quantités de charge $Q_{\mathrm{in,mess}}$ chargées et/ou les quantités de charge $Q_{\mathrm{out,mess}}$ déchargées pendant la période concernée et/ou la somme de leurs valeurs absolues sont supérieures à une valeur respectivement prédéfinie, dans lequel la valeur prédéfinie est de préférence supérieure à la capacité nominale $C_N$ de la batterie (106).

10. Procédé selon l'une des revendications 8 ou 9, **caractérisé en ce que** les instants de fin des première et seconde périodes sont choisis de sorte qu'il existe aux instants de fin le même état de charge $SOC_{ref}$ qu'aux instants de début et/ou qu'il existe aux instants de fin le même sens de courant du courant de batterie $I_{mess}$ mesuré qu'aux instants de début.

11. Procédé selon l'une des revendications 8 à 10, **caractérisé en ce que** les quantités de charge $Q_{in,mod}$ et $Q_{out,mod}$ sont calculées par intégration du courant de batterie $I_{mod}$ calculé à partir du modèle de batterie mathématique dynamique.

12. Procédé selon l'une des revendications 8 à 11, **caractérisé en ce que** la tension à vide $U^0$ est supposée comme dépendant exclusivement de l'état de charge $SOC_{mod}$, **en ce qu'**une résistance interne $R_i$ constante de la batterie (106) est supposée, **en ce qu'**une indépendance vis-à-vis de la température du modèle de batterie est supposée **et en ce que** le courant de batterie $I_{mod}$ est calculé à partir de l'équation obtenue par inversion analytique :

$$I_{\mathrm{mod}} = \frac{1}{R_i}\left(U^0(\mathrm{SOC}_{\mathrm{mod}}) - U_{\mathrm{mess}}\right)$$

dans lequel la dépendance de la tension à vide $U^0$ vis-à-vis de l'état de charge $SOC_{mod}$ est déterminée en particulier par mesure, en particulier en tant que valeurs discrètes mesurées ou en tant que fonction analytique.

13. Procédé selon la revendication 12, **caractérisé en ce que** la tension $U_{mess}$ est détectée en tant que valeurs mesurées de tension discrètes $U_{mess}^i$ à un intervalle de temps $\Delta t$ prédéfini **et en ce que** le courant de batterie $I_{mess}$ est calculé par discrétisation de l'équation selon la revendication 14 en utilisant un procédé de discrétisation mathématique, en particulier en utilisant la méthode d'Euler explicite à partir de l'équation

$$I_{\mathrm{mod}}^i = \frac{1}{R_i}\left(U^0(\mathrm{SOC}_{\mathrm{mod}}^i) - U_{\mathrm{mess}}^i\right)$$

où i représente l'indice d'un intervalle de temps.

14. Procédé selon la revendication 12, **caractérisé en ce qu'**une relation linéaire entre la tension à vide $U^0$ et l'état de charge $SOC_{mod}$ est en outre supposée **et en ce que** le courant de batterie est calculé à partir des relations

$$\frac{d\mathrm{SOC}_{\mathrm{mod}}}{dt} = -\frac{1}{R_i \cdot C_N}\left((U_L - U_E) \cdot \mathrm{SOC}_{\mathrm{mod}} + U_E - U_{\mathrm{mess}}\right)$$

et

$$I_{\mathrm{mod}} = \frac{1}{R_i}\left((U_L - U_E) \cdot \mathrm{SOC}_{\mathrm{mod}} + U_E - U_{\mathrm{mess}}\right)$$

où $U_L$ représente une tension de fin de charge et $U_E$ représente une tension de fin de décharge.

15. Procédé selon la revendication 14, **caractérisé en ce que** la tension $U_{mess}$ est détectée en tant que valeurs mesurées de tension discrètes $U_{mess}^i$ à un intervalle de temps $\Delta t$ prédéfini ou à des instants prédéfinis **et en ce que** la valeur approximative $SOC_{mod}$ pour l'état de charge est calculée par discrétisation de l'équation selon la revendication 16 en utilisant un procédé de discrétisation mathématique, en particulier en utilisant la méthode d'Euler implicite à partir des équations

$$I_{\mathrm{mod}}^{i+1} = \frac{1}{\frac{(U_L - U_E)}{C_N}\Delta t + R_i}\left((U_L - U_E) \cdot \mathrm{SOC}_{\mathrm{mod}}^i + U_E - U_{\mathrm{mess}}^{i+1}\right)$$

et

$$\mathrm{SOC}_{\mathrm{mod}}^{i+1} = \mathrm{SOC}_{\mathrm{mod}}^{i} - \frac{I_{\mathrm{mod}}^{i+1}}{C_{\mathrm{N}}} \Delta t$$

où i représente l'indice d'un intervalle de temps.

**16.** Procédé selon les revendications 8 à 11, **caractérisé en ce**

(a) **qu'**on utilise comme modèle de batterie mathématique un modèle de circuit équivalent qui est décrit par les équations selon les caractéristiques (a) (iv) (1) et (a) (iv) (2) de la revendication 8, dans lequel l'équation selon la caractéristique (a) (iv) (2) de la revendication 8 est remplacée par le système d'équations :

$U_{mess} = U^0(SOC_{mess,}T_{mod} + \Delta U_{hys}(I_{mod}) - U_{RC,an} - U_{RC,ca} - I_{mod} R_s(T_{mod})$

$$(ii) \qquad \frac{\mathrm{d}U_{\mathrm{RC,an}}}{\mathrm{d}t} = \frac{1}{C_{\mathrm{DL,an}}(T_{\mathrm{mod}})}\left(I_{\mathrm{mod}} - \frac{U_{\mathrm{RC,an}}}{R_{\mathrm{CT,an}}(T_{\mathrm{mod}})}\right)$$

$$(iii) \qquad \frac{\mathrm{d}U_{\mathrm{RC,ca}}}{\mathrm{d}t} = \frac{1}{C_{\mathrm{DL,ca}}(T_{\mathrm{mod}})}\left(I_{\mathrm{mod}} - \frac{U_{\mathrm{RC,ca}}}{R_{\mathrm{CT,ca}}(T_{\mathrm{mod}},I_{\mathrm{mod}})}\right)$$

$$(iv) \qquad \frac{\mathrm{d}T_{\mathrm{mod}}}{\mathrm{d}t} = \frac{1}{C_{\mathrm{th}}}\left(I_{\mathrm{mod}}^2 R_s(T_{\mathrm{mod}}) + \frac{U_{\mathrm{RC,an}}^2}{R_{\mathrm{CT,an}}(T_{\mathrm{mod}})} + \frac{U_{\mathrm{RC,ca}}^2}{R_{\mathrm{CT,ca}}(T_{\mathrm{mod}},I_{\mathrm{mod}})} - \frac{T_{\mathrm{mod}} - T_{\mathrm{mess}}^{\mathrm{Umg}}}{R_{\mathrm{th}}} + \right.$$

$$\left. I_{\mathrm{mod}} \cdot (T_{\mathrm{mod}} - T^0) \cdot \frac{\mathrm{d}U^0(SOC_{\mathrm{mod}})}{\mathrm{d}T}\right)$$

où $U_{RC}$ représente une chute de tension aux bornes d'un élément RC, $R_{CT}$ représente une résistance de transfert de charge, $C_{DL}$ représente une capacité de double couche, $C_{th}$ représente une capacité thermique, $R_{th}$ représente une résistance de transfert de chaleur à la surface de la batterie, $dU^0(SOC_{mod})/dT$ représente une dépendance à la température de la tension à vide, $T^0$ représente une température de référence correspondante et $T_{mess}^{Um}$ représente une température ambiante mesurée de la batterie, dans lequel les indices « an » et « ca » renvoient à une anode et à une cathode de la batterie (106) et dans lequel une asymétrie de la tension à vide $U^0$ est décrite par $\Delta U_{hys}$ et une asymétrie de la résistance de la cathode est décrite par une dépendance vis-à-vis du courant de $R_{CT,ca}$,

(b) **que** le courant de batterie $I_{mod}$ est calculé à partir dudit système d'équations, de préférence au moyen d'un ou de plusieurs procédés mathématiques numériques, et

(c) **que** les quantités de charge $Q_{in,mod}$ et $Q_{out,mod}$ sont calculées par intégration du courant de batterie $I_{mod}$ calculé à partir du modèle de batterie mathématique dynamique.

**17.** Dispositif pour la mise en œuvre du procédé selon l'une des revendications 1 à 7, comportant une unité (110) pour la mesure de la tension de batterie $U_{mess}$, de préférence à des intervalles de temps $\Delta t$ équidistants ou à des instants prédéfinis, et comportant une unité (118) pour le calcul d'une valeur approximative $SOC_{mod}$ pour l'état de charge réel SOC de la batterie (106), lequel dispositif est configuré pour la mise en œuvre du procédé selon l'une des revendications 1 à 7.

**18.** Dispositif pour la mise en œuvre du procédé selon l'une des revendications 8 à 16 comportant une unité (110) pour la mesure de la tension de batterie $U_{mess}$, de préférence à des intervalles de temps $\Delta t$ équidistants, comportant une unité (112) pour la mesure du courant de batterie $I_{mess}$ et comportant une unité (118) pour le calcul d'une valeur approximative $SOH_{mod}$ pour l'état de santé réel SOH de la batterie, lequel dispositif est configuré pour la mise en œuvre du procédé selon l'une des revendications 8 à 16.

Fig. 1

Fig. 2

EP 4 045 925 B1

$U_{Rs}$

$U_{RC,an}$

$U_{RC,ca}$

$R_{CT,an}(T_{mod}, SOC_{mod})$

$R_{CT,ca}(T_{mod}, I_{mod}, SOC_{mod})$

$R_s(T_{mod})$

$C_{DL,an}$

$C_{DL,ca}$

$\dfrac{\Delta U_{hys}}{2}$

$\dfrac{\Delta U_{hys}}{2}$

$U_{mess}$

$U^0(SOC_{mod}, T_{mod})$

**Fig. 3a**

$R_{th}$

$T_{amb}$

$C_{th}$

$P_{th}$

$T_{cell}$

**Fig. 3b**

**Fig. 4**

Fig. 5a

Fig. 5b

**Fig. 5c**

**Fig. 6a**

**Fig. 6b**

Fig. 7a

Fig. 7b

**Fig. 8**

**Fig. 9a**

**Fig. 9b**

**Fig. 10a**

**Fig. 10b**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- US 20140203813 A1
- US 20110093223 A1
- US 20190170827 A
- EP 3174175 A1

### In der Beschreibung aufgeführte Nicht-Patentliteratur

- Modeling an parameterization of a commercial LFP/Graphite Lithium-ion cell considering charge and discharge characteristics. **H. KIM**. Masterarbeit. Hochschule Offenburg, 2018
- **CHRISTOPH BIRKL** ; **DAVID HOWEY**. Oxford Battery Degradation Dataset 1. University of Oxford, 2017